# EUROPÄISCHE PATENTANMELDUNG

(11) **EP 3 287 263 A1**
(43) Veröffentlichungstag der Anmeldung: **28.02.2018**
(21) Anmeldenummer: 16185823.8
(22) Anmeldetag: 26.08.2016
(51) Int. Cl.: B29C 67/00, B41C 1/10, G03F 7/00, G03F 7/20

(54) **VORRICHTUNG UND VERFAHREN ZUR LASERGESTÜTZTEN BEARBEITUNG VON KÖRPERN ODER OBERFLÄCHEN**

(71) Anmelder: MULTIPHOTON OPTICS GMBH, 97076 Würzburg (DE)
(72) Erfinder: HOUBERTZ, Ruth, 97074 Würzburg (DE); KRUPP, Alexander, 97076 Würzburg (DE); STENDER, Benedikt, 97074 Würzburg (DE)
(74) Vertreter: Strehl Schübel-Hopf & Partner

(57) **Zusammenfassung**

Die Erfindung betrifft eine Vorrichtung zum lasergestützten Bearbeiten eines an einem Substrat anhaftenden Materials oder eines substratassoziierten oder substratfreien Körpers oder von dessen Oberfläche, insbesondere durch TPA/MPA und/oder durch Behandlung mit einem Ultrakurzpulslaser,
aufweisend
- ein Positioniersystem (9, 10, 11), das eine Probenaufnahme aufweist, wobei die Probenaufnahme so ausgebildet ist, dass sie das Substrat (7), an dem das zu bearbeitende Material haftet oder mit dem der zu bearbeitende Körper assoziiert ist, oder
- in Abwesenheit eines Substrats - den zu bearbeitenden Körper (7) halten kann,
- eine Laserquelle (1), die Laserpulse bzw. Laserpulsfolgen aussenden kann,
und
- eine Fokussieroptik (6), die die Laserpulse bzw. Laserpulsfolgen so formen kann, dass diese in einem Brennpunkt oder einem fokalen Volumen im Bereich des zu bearbeitenden Materials bzw. Körpers derart auftreffen, dass dort eine 2- oder Mehrphotonenpolymerisation stattfinden kann, oder dass diese in einem Brennpunkt oder in einem fokalen Volumen im Bereich des Körpers derart auftreffen, dass in diesem Brennpunkt oder fokalen Volumen befindliches Material den gewünschten chemischen und/oder physikalischen Veränderungen unterworfen wird .

Eine Vielzahl von Bearbeitungsverfahren ist unter Einsatz dieser Vorrichtung möglich.

## Beschreibung

Die vorliegende Erfindung betrifft eine Vorrichtung zur lasergestützten Bearbeitung von Körpern oder Oberflächen sowie Verfahren, die sich dieser Vorrichtung bedienen. Die Vorrichtung eignet sich z.B. zur Erzeugung dreidimensionaler Strukturen, beispielsweise von oder in Körpern, oder von oder in Oberflächen aus einem zu verfestigendem Material oder zur Bearbeitung von Oberflächen oder Körpern, bevorzugt aus Glas oder Glaskeramik oder Metall oder von metallischen Filmen oder Strukturen auf einer nichtmetallischen Oberfläche, bevorzugt durch ortsselektives Bestrahlen mit Hilfe von Zwei- oder Mehr-Photonen-Absorptionsprozessen (nachfolgend abgekürzt als TPA für two-photon absorption oder MPA für multi-photon absorption bezeichnet) oder mit Hilfe von gepulsten Lasern wie Ultrakurzpulslasern.

3D-Lithographieanlagen (auch als hoch-präzise 3D-Drucker bezeichnet) zur additiven und subtraktiven Fertigung mehrdimensionaler Strukturen auf/in beliebig geformten Oberflächen / Volumina mittels Mehr-Achsen-Systemen unter Ausnutzung von Mehr-Photonen-Prozessen sind dem Grunde nach bekannt.

Aus dem Stand der Technik ist unter anderem bekannt, dreidimensionale Körper oder Oberflächenstrukturen z.B. durch lichtinduzierte Prozesse, insbesondere durch organische Vernetzung zu erzeugen, indem zunächst nur eine Schicht oder Ebene als zweidimensionaler Bestandteil der zu erschaffenden Struktur erzeugt wird und der dreidimensionale Aufbau des Körpers bzw. der Oberflächenstruktur durch sukzessives Prozessieren von aufeinander folgenden zweidimensionalen Schichten oder Ebenen aufgebaut wird. Beispiele für solche zweidimensional arbeitenden Verfahren sind Stereolithographie, selektives Lasersintern (SLS) oder 3D-Drucken (3DP). Nachteilig an zweidimensionalen Verfahren sind die verhältnismäßig langen Produktionszeiten, da die herzustellenden Körper schichtweise generiert werden und nach jeder erfolgten Schichtverfestigung eine neue zu verfestigende Schicht präpariert werden muss. Durch die Schichtpräparation ist die minimale Schichtdicke außerdem auf 20 µm, bestenfalls 10 µm beschränkt. Diese Nachteile wiegen besonders schwer, wenn die herzustellenden Körper mit Größen bis in den Milli- und Zentimeterbereich mit hoher Oberflächengüte erzeugt werden sollen. Unter anderem am 3D-Drucken ist beispielsweise die schlechte Oberflächengüte nachteilig.

Schnellere Prozesse als die Stereolithographie bieten dreidimensionale Verfahren, bei denen materialmodifizierende Strahlung direkt im Volumen eines noch unbearbeiteten, festen oder flüssigen Ausgangsmaterials interagiert. Aus der WO 03/037606 A1 ist die Verwendung von Zwei- oder Mehrphotonenpolymerisation bei der Verfestigung organopolysiloxanhaltiger Materialien bekannt (die Polymerisation erfolgt durch Zwei-(TPA) oder MehrphotonenAbsorption). Dabei wird Strahlung einer Wellenlänge verwendet, die unter normalen Umständen im Reaktivmaterial nicht absorbiert wird. Durch Fokussierung femtosekundenlanger Laserpulse in das Material kommt es im Brennpunkt oder dem fokalen Volumen der Optik zu Mehrphotonenabsorption, wodurch ähnliche chemische Veränderungen, wie bei einer Benutzung von Laserstrahlung deutlich kürzerer Wellenlängen, induziert werden können. Materialveränderungen können so gezielt im dreidimensionalen Raum ausgelöst werden.

DE 101 11 422 A schlägt für ein derartiges Verfahren vor, den Badbehälter mit dem zu verfestigenden Material auf einem in der X-Y-Ebene verfahrbaren Tisch anzuordnen und in diesem eine Bauplattform vorzusehen, die in Z-Richtung gesteuert verfahrbar ist, um den Brennpunkt (Fokalbereich) in geeigneter Weise variabel positionieren zu können. Dabei erfolgt die Belichtung von oben in die offene Badoberfläche hinein. Alternativ erfolgt eine Bewegung des Fokus' in X- und in Y-Richtung mit Hilfe eines Scannersystems, d.h. mit einem oder mehreren beweglichen Spiegel(n). Bei diesem System kann keine hohe numerische Apertur der Optik verwendet werden und damit keine hohe Strukturauflösung bei gleichzeitig frei wählbarer Formkörpergröße erzielt werden. Fehler entstehen außerdem durch das Belichten über die offene Badoberfläche, die keine saubere optische Oberfläche darstellt.

In WO 2011/141521 A1 werden zwei verschiedene Vorrichtungen zur Erzeugung dreidimensionaler Strukturen aus einem zu verfestigenden Material infolge lichtinduzierter organischer Vernetzung beschrieben. Die Vorrichtungen weisen jeweils eine Laserquelle, eine bewegbare Fokussieroptik zur Ausbildung eines oder mehrerer Laserfoki und einen Materialbehälter für das zu verfestigende Material auf. In der ersten Vorrichtung besteht der Materialbehälter wenigstens teilweise aus einem für die verwendete Laserstrahlung durchlässigen Material und ist so im Strahlengang angeordnet oder anordbar, dass die Laserstrahlung durch den Materialbehälter in das zu verfestigende Material einbringbar ist, der Materialbehälter als optisch definierte Grenzfläche wirkt und in dem Materialbehälter eine gegenüber diesem positionierbare Trägereinheit angeordnet ist. Bevorzugt ist dabei die Fokussieroptik wenigstens in einer Ebene verschiebbar ausgebildet, während die Trägereinheit senkrecht dazu verfahrbar ist. Besonders bevorzugt befindet sich die Fokussiereinheit unterhalb des Badbehälters und ist mindestens in der horizontalen Ebene (X-Y) verschiebbar, während die Trägereinheit senkrecht dazu in Z-Richtung verfahrbar ist. Die Fokussiereinheit kann in Ausnahmefällen stattdessen oberhalb des Badbehälters angeordnet sein, wenn dieser einen Deckel besitzt und das Badmaterial bis an den Deckel reicht. In einer Variante der Erfindung befindet sich die Fokussieroptik seitlich des Badbehälters und ist mindestens in einer X-Z- oder Y-Z-Ebene bewegbar, während die Trägereinheit entsprechend in Y- bzw. in X-Richtung verfahrbar ist. In der zweiten dieser Vorrichtungen ist die Fokussieroptik gegenüber dem zu verfestigenden Material dicht und in das zu verfestigende Material in dem Materialbehälter eintauchbar angeordnet, so dass eine Strahlaustrittsfläche der Fokussieroptik selbst die optisch definierte Grenzfläche ausbildet. Bevorzugt ist dabei die Fokussieroptik in allen drei Raumrichtungen bewegbar und damit frei im Bad positionierbar. Entsprechende Verfahren unter Nutzung der Vorrichtungen werden in dieser Druckschrift ebenfalls offenbart.

Für den Badaufbau der WO 2011/141521 A1 wird ein Objektiv mit hoher NA verwendet, auch für den Fall, dass große Formkörper hergestellt werden sollen. Denn diese Formkörper sind erfindungsgemäß unabhängig vom Arbeitsabstand herstellbar. Daher kann frei ausgewählt werden, ob feine, hochaufgelöste Strukturen oder- durch Erhöhung der Laserleistung - ebenfalls breite Linien und damit eine erhöhte Baurate erreicht werden sollen (die Linien werden bei Erhöhung der Laserleistung breiter, weil die Verfestigungsbedingungen in einem breiteren Raumbereich erfüllt sind (Schwellwertprozess)).

Es lassen sich jedoch auch sehr kleine Strukturen herstellen. Für diese Fälle ist ein Materialbehälter für das zu verfestigende Material nicht erforderlich. Beispielsweise kann das zu verfestigende Material auf einem Substrat aufgetragen werden, z.B. in Form eines Tropfens oder als Schicht. Wird durch das Substrat hindurch belichtet, muss dieses natürlich lichtdurchlässig sein; weitere Bedingungen gibt es nicht. Das Material kann von unten, von oben oder von der Seite belichtet werden; es kann auf einem Substrat liegend mit einem zweiten Substrat abgedeckt sein oder auch nicht.

Der Badaufbau der WO 2011/141521 A1 eignet sich insbesondere zur schnellen Herstellung von spezifisch und beliebig geformten Funktionselementen auf beispielsweise planaren oder zylindrischen Substraten. Dazu gehören z.B. optische Elemente für Anwendungen im Bereich der (Bio)-Photonik und Antireflexschichten. Auch die parallele Herstellung von photonischen Kristallen für künftige photonische Schaltkreise und Bauelemente ist möglich. Außerdem können die mit der Vorrichtung erzeugten Strukturen in der Mikromechanik (als MEMS oder MOEMS) und der Mikro- und Nanoelektronik, sowie in Quantenbauelementen und der Polymerelektronik eingesetzt werden. Darüber hinaus ist ein Einsatz des Strukturierungsdevices im Life-Science-Bereich, z.B. in der Orthopädie (u. a. Prothetik), der regenerativen Medizin (z. B. als Trägerstrukturen) und in der Pharmazie (u. a. als Drug-Delivery-Systeme) möglich.

Mit den Vorrichtungen der WO 2011/141521 A1 ist es also möglich, dreidimensionale Körper beliebiger Form aus zu verfestigenden Materialen durch lichtinduzierte Vernetzungsprozesse über einen weiten Wellenlängenbereich unter Verwendung verschiedenster Laser- und optischer Systeme in situ herzustellen. Es kann generell eine Vielzahl an Material- und Stoffklassen parallel und großflächig bearbeitet werden. Nach der Lehre dieser Druckschrift wird ein Badaufbau, d.h. ein Materialbehälter eingesetzt, der als Gefäß für das zu verfestigende Material dient, das ja in der Regel flüssig oder viskos ist. Doch gelingen die in WO 2011/141521 A1 beschriebenen Verfahren genauso gut mit Vorrichtungen, in denen kein Behälter mit Wänden verwendet wird, sofern die Menge an zu verfestigendem Material nicht so groß ist, dass sie von solchen Wänden gehalten werden muss. Es genügt ein beliebig geformtes, ggf. lichtdurchlässiges Substrat.

Lasergestützte Bearbeitungen sind erfindungsgemäß beispielsweise Verfestigungen von flüssigen oder pastösen Materialien (organischen Polymeren, anorganisch-organischen Hybridpolymeren, oder mit Nanopartikeln gefüllte organische oder anorganisch-organische Polymere) mit Hilfe von MPA/TPA, das strukturelle Ändern der Löslichkeit von Teilen bereits fester Materialien (organischer Polymere, anorganisch-organischer Hybridpolymere) mit Hilfe von MPA/TPA (insbesondere durch Bindungsbruch), das strukturelle Verändern von physikalischen Eigenschaften von Gläsern oder Glaskeramiken, wobei im Falle von geeignet vorbehandelten Gläsern/Glaskeramiken in deren Innerem z.B. Phasenübergänge und/oder Redoxreaktionen ausgelöst werden, die zu einer veränderten, z.B. erhöhten Löslichkeit gegenüber einem Solvens, wie HF, NH₄F oder Mischungen davon, führen können, und das Bearbeiten fester Oberflächen (anorganisch, organisch, anorganisch-organisch oder metallisch) mit Hilfe von MPA/TPA. Ebenfalls umfasst von der Erfindung sind lasergestützte Oberflächenbehandlungen von Metallen und anderen Materialien: Es ist z.B. möglich, mit Hilfe von gepulsten Lasern, wie Ultrakurzpulslasern, Metalle zu strukturieren, wobei Material der Oberfläche verdampft oder ablatiert wird. Mit diesem Verfahren gelingt beispielsweise die Herstellung extrem feiner Bohrungen. Die vorgenannten Bearbeitungsverfahren sind nicht abschließend zu verstehen.

Unter dem Ausdruck "sich bildende Struktur" soll in der vorliegenden Erfindung das Produkt der Laserbehandlung, insbesondere der TPA bzw. MPA bzw. der Behandlung mit gepulsten Lasern, wie beispielsweise Ultrakurzpulslasern, allgemein zu verstehen sein. Das kann z.B. ein verfestigtes Material sein, wenn die TPA/MPA eine Polymerisationsreaktion in einem organischen oder organisch-anorganischen Hybridmaterial auslöst, es kann eine durch Auflösen eines Festkörpers sich bildende Struktur sein, wenn die TPA/MPA einen Bindungsbruch auslöst; es kann aber auch eine Struktur sein, die andere physikalische Eigenschaften hat als das nicht mit TPA/MPA belichtete Material, die z.B. löslicher oder weniger löslich ist, oder eine andere Struktur, die direkt oder indirekt durch das ortsselektive Bestrahlen mit Hilfe von TPA oder MPA entsteht.

Der Ausdruck TPA/MPA wird, wie erwähnt, erfindungsgemäß für eine Zwei- und/oder Mehrphotonenpolymerisation verwendet, wobei ein nichtlineares Verhalten vorliegt. Eine Reaktion findet nur nur in einem Raumbereich statt, in dem die Laserintensität diesen Schwellwert überschreitet. So kann die Reaktion räumlich sehr eng begrenzt stattfinden, wodurch die Erzeugung von hochgenauen Strukturen ermöglicht wird und findet außerhalb des fokalen Volumens mit ausreichender Intensität nicht bzw. mit reduzierter Effizienz statt, so dass sich durch Formung des fokalen Volumens geeignete Intensitätsprofile herstellen lassen, die zu unterschiedlichen Materialeigenschaften in einem einzigen Material und bedarfsweise auch in einem einzigen Prozessschritt führen.

Eine Polymerisationsreaktion kann die TPA/MPA beispielsweise an organischen oder organisch modifizierten anorganischen Materialien, wie organisch modifizierten Polysiloxanen oder Mischungen davon, auslösen, die organisch polymerisierbare C=C-Bindungen oder andere lichtinduziert polymerisierbare Gruppen aufweisen. Diese können ungefüllt oder mit Nano- oder Mikropartikeln gefüllt sein. Alternativ kann die TPA/MPA Bindungsbruchprozesse auslösen, wodurch sich Löslichkeitsveränderungen in einstellbarem Umfang erzielen lassen. Des Weiteren können Redox-Prozesse, Umstrukturierungsprozesse und/oder Phasenübergänge, z.B. Kristallbildung in Gläsern und Glaskeramiken, durch die TPA/MPA induziert und dabei mit Hilfe geeigneter Vorrichtungen dreidimensional stark lokalisiert und kontrolliert werden.

Metallische Oberflächen, metallische Körper (z.B. mit Abmessungen im cm- oder dm-Bereich) oder metallische Filme oder Strukturen auf den vorgenannten Materialien lassen sich mit Hilfe von gepulsten Lasern, insbesondere von Ultrakurzpulslasern, ortsselektiv bearbeiten: Als Laserablation, auch Laserverdampfen genannt, wird das Abtragen von Material von einer Oberfläche durch Beschuss mit gepulster (oder cw) Laserstrahlung bezeichnet. Die hierbei Verwendung findende Laserstrahlung mit hoher Leistungsdichte führt zur rapiden Erhitzung und der Ausbildung eines Plasma an der Oberfläche. Mit Ultrakurzpulslasern können aber auch oberflächlich ortsselektiv Schmelzen oder Verdampfen ohne Plasmabildung erzeugt oder Legierungen ausgebildet werden. Es ist daher möglich, mit Hilfe von Ultrakurzpulslasern Metalle sehr fein zu strukturieren oder sehr fein ihre oberflächliche Zusammensetzung zu verändern. Mit Ultrakurzpulslasern gelingt beispielsweise die Herstellung extrem feiner Bohrungen. Diese müssen genau im Material platziert werden, d.h. es ist erforderlich, dass der Energieeintrag durch den Lichtstrahl genau senkrecht bzw. in einem beliebigen, genau definierten Winkel auf die Metalloberfläche fällt. Handelt es sich um einen Gegenstand mit unregelmäßiger Oberfläche, kann dies nicht oder nur unter erheblichem Aufwand für die Bewegung der Komponenten gelingen.

Mit gepulsten Lasern, insbesondere Ultrakurzpulslasern bearbeitete metallische Strukturen sollen erfindungsgemäß ebenfalls unter den Ausdruck "sich bildende Struktur" zu subsumieren sein.

Auch Gläser lassen sich mit Hilfe der Erfindung bearbeiten.

Des Weiteren kann Metall unter Einsatz von Polymeren auf beliebig geformten Flächen und Materialien mit Hilfe von TPA/MPA und eines Metallisierungsprozesses aufgebracht werden: Ein Substrat oder ein Körper wird hierbei mit einem Polymer-Vorläufer beschichtet und zur Auslösung eines Zwei- oder Mehr-Photonen-Prozesses mit einem Ultrakurzpulslaser belichtet. Dabei wird die Löslichkeit des Materials in den belichteten Bereichen gegenüber der in den unbelichteten Bereichen erhöht, so dass das Material aus den belichteten Bereichen mittels eines Lösemittels oder Lösemittelgemischs weggewaschen werden kann. Es schließt sich eine flächige Metallisierung durch Beschichtungsprozesse wie Aufdampfen, Aufsputtern, galvanische Abscheidung oder (gepulste) Elektrodeposition und danach ein Lift-Off des verbliebenen, beschichteten Polymers an, wobei die Metallisierung nur an den Stellen auf dem Substrat oder dem Körper verbleibt, an denen das Polymer weggewaschen wird. So lassen sich Metallstrukturen von unter 1 µm, bevorzugt unter 500 nm und ganz besonders von 100 nm erzeugen.

Vorrichtungen, die für die vorgenannten Verfahren geeignet sind, also zum lasergestützten Bearbeiten eines an einem Substrat anhaftenden Materials oder eines substratassoziierten oder substratfreien Körpers oder von dessen Oberfläche, insbesondere durch TPA/MPA und/oder durch Behandlung mit einem gepulsten Laser, beispielsweise einem Ultrakurzpulslaser, weisen in der Regel die folgenden Komponenten auf:
- ein Positioniersystem (9 10, 11), mit einer Probenaufnahme, wobei die Probenaufnahme so ausgebildet ist, dass sie das Substrat (7), an dem das zu bearbeitende Material haftet oder mit dem der zu bearbeitende Körper assoziiert ist, oder - in Abwesenheit eines Substrats - den zu bearbeitenden Körper (7) halten kann,
- eine Laserquelle (1), die Laserpulse bzw. Laserpulsfolgen aussenden kann, und
- eine Fokussieroptik (6), die sich meist oberhalb der Probenaufnahme oder seitlich (24) oder unterhalb des von der Probenaufnahme gehaltenen Substrats (7) oder Körpers (7) befindet und die Laserpulse bzw. Laserpulsfolgen so formen kann, dass diese in einem Brennpunkt oder einem (relativ zu einem Brennpunkt gesehen) ausgedehnteren fokalen Volumen im Bereich des zu bearbeitenden Materials bzw. Körpers derart auftreffen, dass dort eine 2- oder Mehrphotonenpolymerisation stattfinden kann, oder dass diese in einem Brennpunkt oder in einem ausgedehnteren fokalen Volumen im Bereich des Körpers derart auftreffen, dass in diesem Brennpunkt befindliches Material den gewünschten chemischen und/oder physikalischen Veränderungen, z.B. einer Bindungsbruchreaktion, unterworfen wird, flüssig oder dampfförmig wird und/oder sublimiert und/oder einem Phasenübergang und/oder einem Redox-Prozess unterworfen wird.

Unter dem Ausdruck "Probenaufnahme" des Positioniersystems soll ein Bereich dieses Systems zu verstehen sein, auf oder an dem das Substrat oder der Körpers gelagert oder befestigt sein kann. Es kann sich, muss aber nicht, um eine ebene Fläche handeln. Die Fläche kann auch Durchbrüche aufweisen, oder die Probenaufnahme kann aus einer Stangenkonstruktion oder dgl. gebildet sein oder eine solche umfassen. Bevorzugt ist die Probenaufnahme Bestandteil eines der Träger oder des einzigen Trägers des Positioniersystems, der z.B. als Hexapode ausgestaltet sein kann, und in diesen Fällen insbesondere in Form von dessen zweiter Basis. Die Probenaufnahme kann stattdessen mit einer anderen Komponente des Positioniersystems auf beliebige Weise verbunden, beispielsweise verschraubt sein.

Wenn das Substrat oder der Körper unmittelbar auf der Probenaufnahme der Vorrichtung angeordnet ist, befindet es/er sich direkt auf dieser Probenaufnahme. Im Falle der Verwendung eines Positioniersystems, das eine Plattform oder Basis besitzt, kann es sich bei der Probenaufnahme um diese Plattform oder Basis handeln. Alternativ kann sich z.B. eine Halterung für das Substrat oder den Körper auf der Probenaufnahme befinden. In diesem und vergleichbaren Fällen ist das Substrat/der Körper im Sinne der Erfindung "mittelbar" auf der Probenaufnahme angeordnet.

In allen Fällen sollte das Substrat/der Körper auf der Probenaufnahme befestigt sein, um nicht herunterfallen oder umgestoßen werden zu können. Dies gilt insbesondere dann, wenn das Substrat/der Körper nicht so auf der Probenaufnahme zu liegen kommen kann, dass es/er von der Schwerkraft auf der Probenaufnahme sicher und zuverlässig gehalten wird. Da die Vorrichtung für sehr unterschiedliche Verfahren und auch für sehr unterschiedlich große und unterschiedlich geformte Substrate/Körper geeignet ist, wäre es wünschenswert, diese Befestigung so zu gestalten, dass die unterschiedlichsten Substrate/Körper in den unterschiedlichsten Lagen und Anordnungen gehalten werden können, ohne jeweils für den Einzelfall spezielle Lösungen für die Halterung vorhalten oder neu konstruieren zu müssen. Es ist daher Aufgabe der vorliegenden Erfindung, die in Rede stehende Vorrichtung so auszugestalten, dass darin beliebige Substrate oder Körper beliebiger Größe und in beliebiger Lage sicher gehalten werden können.

In Lösung dieser Aufgabe ist es vorgesehen, dass das Substrat oder der Körper über eine Luftabsaugung auf der Probenaufnahme fixiert wird. Eine solche Luftabsaugung ist auf dem Gebiet der Waferbearbeitung bekannt unter dem Namen "Wafer Chuck". Der Ausdruck "Chuck" soll daher nachstehend diese Art der Halterung charakterisieren. Der Chuck besitzt erfindungsgemäß die Form eines Hohlkörpers, dessen obere Seite als Lochplatte mit oder ohne Nuten zur Lagerung des Substrats oder Körpers ausgestaltet ist und der eine Absaugöffnung zur steuerbaren Luftabsaugung aufweist. Diese Absaugöffnung kann beliebig, z.B. in Form der gesamten Unterfläche oder in Form einer Öffnung mit oder ohne Ventil und in variierender Größe und Form, ausgebildet sein. Damit können das Substrat bzw. der Körper über Saugkräfte (Vakuum) fixiert werden.

Die beigefügten Figuren erläutern die Erfindung näher, worin
Fig. 1 eine Übersicht über die Komponenten der erfindungsgemäßen Vorrichtung gibt,
Fig. 2 eine erste Variante der Erfindung zeigt, in der ein auf einem Substrat (hier z.B. eine Linse) befindliches Material mit Hilfe einer sich oberhalb befindenden Fokussieroptik bearbeitet werden kann,
Fig. 3 eine zweite Variante der Erfindung zeigt, in der das Substrat mit Komponenten bestückt ist und das zu bearbeitende Material zwischen und oberhalb der Komponenten liegt,
Fig. 4 eine dritte Variante der Erfindung zeigt, in der sich das zu bearbeitende Material zwischen zwei Substraten befindet, die optional durch Abstandselemente voneinander beabstandet gehalten werden,
Fig. 5 eine vierte Variante zeigt, in der ein zu verfestigendes Material in einem Behälter angeordnet ist und die Fokussieroptik so ausgerichtet ist, dass das Laserlicht von oben (Fig. 5a) bzw. von unten (Fig. 5b) in den Behälter eingestrahlt wird,
Fig. 6 eine fünfte Variante zeigt, in der ein zu verfestigendes Material an einem Substrat hängt und durch das Substrat hindurch bestrahlt wird,
Fig. 7 eine sechste Variante zeigt, in der ein dünnes, transparentes Substrat beidseitig mit Material belegt ist, wobei die Einstrahlungsbedingungen so gewählt werden, dass beide Seiten gleichzeitig oder nacheinander bearbeitet werden,
Fig. 8 eine siebte Variante zeigt, in der die Fokussieroptik als Eintauchoptik gestaltet ist und in das zu verfestigende Material, das sich in einem Behälter befindet, eintaucht, und
Fig. 9 eine achte Variante zeigt, bei der ein Substrat oder ein Körper auf einer drehbaren Achse gelagert ist, und
Fig. 10 rein schematisch die Möglichkeit zeigt, das Material oder den Körper mit Hilfe einer oder mehrerer seitlich hierzu angeordneter Fokussieroptik(en) zu bearbeiten.

In einer besonderen Ausführungsform der Erfindung ist die Lochplatte des Chucks abnehmbar gestaltet und der Rest des Hohlkörpers so ausgestaltet, dass seine Oberseite durch verschieden große und/oder verschieden geformte Lochplatten abgeschlossen werden kann, so dass beliebig geformte Substrate oder Körper aufgenommen werden können, wie beispielsweise Substrate in Waferform, Mikroskopiergläser, bestückte oder unbestückte Leiterplatten, elektrische oder elektrisch/optische, noch nicht verkapselte (Mikro-)Bauelemente oder verpackte elektrooptische oder optische Bauelemente mit oder ohne Glasfasern bzw. Glasfaserarrays, wobei diese Aufzählung lediglich exemplarisch und nicht einschränkend zu sehen ist.

In einer alternativen Ausführungsform hierzu, die auch kumulativ mit der vorherigen eingesetzt werden kann, ist der Chuck in mehrere Bereiche unterteilt, deren Luftabsaugung getrennt voneinander gesteuert werden kann. Die Steuerung kann beispielsweise mit Hilfe von Ventilen erfolgen. Auf einem solchen Chuck können Substrate oder zu bearbeitende Körper unterschiedlicher Form und Größe gehalten werden. Beispielsweise kann der Chuck einen inneren Bereich aufweisen, der mit den sich mittig befindenden Löchern der Lochplatte in Kontakt steht, um kleine Körper oder Substrate zu fixieren, sowie um diesen Bereich herum einen oder mehrere ringartige und/oder streifenförmige Bereiche, die zusätzlich zur Absaugung herangezogen werden können, wenn die Körper oder Substrate größer sind. Das Vakuum in den einzelnen Bereichen kann unterschiedlich gewählt werden und die Bereiche können auch getrennt voneinander aktiviert und deaktiviert werden. So kann es günstig sein, in weiter außen liegenden Ringen ein stärkeres Vakuum aufzubauen, um auch große Substrate bzw. Körper mit beispielsweise unterschiedlichen Schwerpunkten stabil halten zu können.

Für den Fall, dass die erfindungsgemäße Vorrichtung ein Substrat nutzt, welches auf seiner Unterseite nicht ganz eben ist, wie es beispielsweise bei einer bestückten Leiterplatte oder einem elektrischen oder optischen oder elektrisch-optischen Bauelement vorkommen kann, kann zusätzlich eine Auflage auf dem Chuck vorgesehen sein. Bei dieser Auflage kann es sich um eine flexible oder nicht flexible, feste Auflage handeln, die derart gestaltet ist, dass immer noch die Ansaugung des Substrats durch den Chuck gewährleistet wird. Sie sollte eine derartige Dichtigkeit und beliebig angeordnete Löcher und Nuten besitzen, dass ein beliebig geformtes und beliebig großes Lochmuster des Chucks eine beliebige Probe über das Vakuum festhalten kann. Es kann sich dabei um eine starre oder eine flexible Auflage handeln, beispielsweise eine gummierte Auflage (Matte) oder eine Silikonmatte, in die vorzugsweise kleine Löcher und/oder Nuten eingebracht wurden. Flexible Matten sind günstig, um unterseitig unebene Körper oder Substrate zu halten, wie beispielsweise elektrische oder (elektro)optische Bauelemente, die häufig Lotkugeln oder dergleichen an ihrer Unterseite aufweisen. Solche Unebenheiten können von einer flexiblen Matte, in die sie sich eindrücken, aufgefangen werden.

Der Chuck dient als variabel ausgestaltete bzw. ausgestaltbare Probenaufnahme; er kann bei Bedarf jedoch auch zur Egalisierung und zum Ausgleich eines Keilfehlers ausgestaltet und genutzt werden. Die Nutzung von Keilfehlerausgleichen ist dem Fachmann aus dem Stand der Technik dem Grunde nach bekannt.

In einer ersten spezifischen Ausgestaltung der Erfindung wird für das Positioniersystem ein einziger oder erster Träger in Form einer Einrichtung genutzt, die mindestens drei translatorische und drei rotatorische Freiheitsgrade ermöglicht. Besonders bevorzugt besitzt sie bis zu sechs auf einer ersten Basis montierte Beine, deren Länge und Winkel variabel sind und die mit einer zweiten Basis in geeigneter Anordnung verbunden sind (beispielsweise ein Hexapode).

Hexapoden sind aus dem Stand der Technik bekannt. Sie zeichnen sich durch das Vorhandensein von drei Linearachsen und drei Rotationsachse aus, die häufig auf sehr kleiner Fläche angeordnet sind, und besitzen eine hohe Dynamik. Die Eigenmasse und der Anteil an Masse, der bewegt werden muss, ist sehr gering, so dass sie eine geringe Trägheit aufweisen und hohe Beschleunigungen und Endgeschwindigkeiten erreichen können, weshalb sie sich auch für sehr schnelles Verfahren mit Bewegungen in beliebiger Art eignen. Alle Achsen zeigen üblicherweise ein (nahezu) identisches dynamisches Verhalten, sehr geringes Übersprechen der Achsen und weisen eine hohe Steifigkeit auf. Der Vorteil von Hexapoden liegt vor allem in der freien Definition des Drehpunktes. Durch die Beweglichkeit des Hexapoden bzw. vergleichbarer Vorrichtungen wird erfindungsgemäß die Strukturierung auch auf gekrümmten Oberflächen, wie beispielsweise auf Hohlspiegelkörpern oder anderen beliebigen Freiformflächen, möglich.

Zusätzlich zu dem genannten ersten Träger kann das Positioniersystem in spezifischen Ausgestaltungen auch noch einen zweiten Träger umfassen, der eine Bewegung in X-Y-Richtung und/oder Z-Achse ausführen kann und/oder eine Rotationsachse aufweist. Dieser Träger wird auch als Positionierstage bezeichnet. Er kann mit dem ersten Träger auf beliebige Weise verbunden bzw. an ihm befestigt sein, beispielsweise mit Hilfe von Klemmen, oder der zweite Träger kann in den ersten Träger eingebettet sein und/oder diesen mit Hilfe eines Ansaugvakuums halten.

Erfindungsgemäß wird als zweiter Träger, sofern vorhanden, ein Träger eingesetzt, der eine lineare Positionierung in den Ebenen des Raumes und/oder eine Positionierung um wenigstens eine rotierbare Achse (z.B. montierbar auf die X-Y-Positionierstage, z.B. einem Positioniertisch oder einer anderen, nicht zwingend als Tisch ausgebildeten Positionierstage) ermöglicht. Das kann beispielsweise ein Träger sein, bei dem eine Rotationsachse auf eine in X-Y-Richtung bewegbare Positioniereinheit montiert ist. Die Positioniereinheit kann Bewegungen in X- und Y-Richtung vollführen, und die Rotationsachse kann eine Drehbewegung vollführen, wobei die Länge der Rotationsachse in Z-Richtung vorzugsweise veränderbar ist, z.B. durch Aus- und Einfahren der Stange, so dass die Höhe des ersten Trägers durch den zweiten Träger eingestellt werden kann. Der zweite Träger kann auch aus mehreren Teilträgern (Teil-Positionierstages) aufgebaut sein. Der zweite Träger kann unabhängig davon, ob er eine einzelne Positionierstage darstellt oder aus mehreren Teileinheiten aufgebaut ist, beliebig gelagert, z.B. luftgelagert, sein und beliebig angetrieben werden, beispielsweise mechanisch und/oder piezoelektrisch.

Ist ein zweiter Träger vorhanden, so kann er als Basis der Vorrichtung dienen, beispielsweise, wenn es sich dabei um einen linear verschiebbaren Tisch oder eine in Z-Richtung drehbare Achse handelt. In diesen Fällen ist der erste Träger auf dem zweiten Träger angeordnet. Es ist aber nicht zwingend, dass der erste Träger auf dem zweiten Träger befestigt ist. Je nach Bedarf kann stattdessen der zweite Träger auf dem ersten Träger angeordnet sein, oder beide Träger befinden sich seitlich nebeneinander, wobei sich dann die Probenaufnahme in der Regel an einem seitlichen Ende der Trägerkonstruktion befindet.

In einer zweiten spezifischen Ausgestaltung der Erfindung umfasst das Positioniersystem den zweiten Träger wie voranstehend beschrieben, nicht aber den ersten.

Unter "Fokussieroptik" wird erfindungsgemäß eine fokussierende Einrichtung verstanden, vorzugsweise eine Linse oder ein Linsensystem, die oder das in einem Gehäuse untergebracht sein und zusätzliche Komponenten aufweisen kann.

Jede Fokussieroptik kann gegenüber anderen Elementen der Strahlführung und/oder dem Materialbehälter und/oder dem zu verfestigenden Material und/oder der Trägereinheit bewegbar sein, so dass zur Positionierung lediglich die Fokussieroptik allein bewegt werden muss und verbleibende Elemente der Strahlführung fest installiert sein können. Insbesondere im Falle einer Positionierung über eine Bewegung der Optik kann die Laserstrahlung mit besonderem Vorteil wenigstens in Teilbereichen der Strahlführung über Lichtwellenleiter geführt werden.

Zur Vermeidung von Abbildungsfehlern beim Fokussieren können nach der Erfindung Hybridoptiken aus diffraktiven optischen Elementen und konventionellen Linsen eingesetzt werden. Die diffraktiven optischen Elemente sind beispielsweise aus Quarzglas, organopolysiloxanhaltigen Materialien, Flüssigkeiten oder beliebigen Materialkombinationen, beispielsweise in Schichtsystemen oder strukturierten Schichten, hergestellt. Optisch initiiert werden können sie durch elektrische Potentiale, magnetische Signale oder durch Oberflächenspannungen, die variabel einstellbar sein können, beispielsweise durch molekulare Schichten, die durch Anlegen einer Spannung ihre Orientierung derart ändern, dass sich die Polarität der Oberfläche kontrolliert ändern lässt. Bei der Verwendung von Fokussieroptiken, welche ohne Brechungsindexanpassung eingesetzt werden, erhält man bei variablen Eindringtiefen des Lichtes in das Material einen Positionierungsfehler, der auf Grund von Brechung an der Grenzfläche Luft-Material (d.h. die Bewegung des fokalen Brennvolumens stimmt nicht mit der Bewegung der Optik überein) entsteht. Diese Abweichung in der Z-Positionierung des Brennvolumens kann über einen Korrekturfaktor, z. B. in der Maschinensoftware implementierten Faktor, kompensiert werden, oder ggf. durch ein Korrekturrad an der Fokussieroptik, die es erlaubt, die Abbildungsfehler/ Aberrationen auf die gewünschte Arbeitsposition hin zu minimieren.

Die Vorrichtung und das Verfahren der vorliegenden Erfindung sind mit Vorteil nicht durch Beugungsbegrenzungen der Fokussieroptiken beschränkt, weil zum einen ein anderes Absorptionsverhalten als bei linearer Ein-Photonen-Absorption vorliegt und zum anderen ein Schwellwertprozess ausgenutzt wird. Das Absorptionsprofil (näherungsweise Gauß- oder auch Lorenz-Profil) bei Mehrphotonenabsorption ist weiterhin schmaler, wodurch eine bessere Auflösung möglich ist, da ein nichtlinearer Zusammenhang zwischen der Photonendichte und dem Absorptionsverhalten besteht.

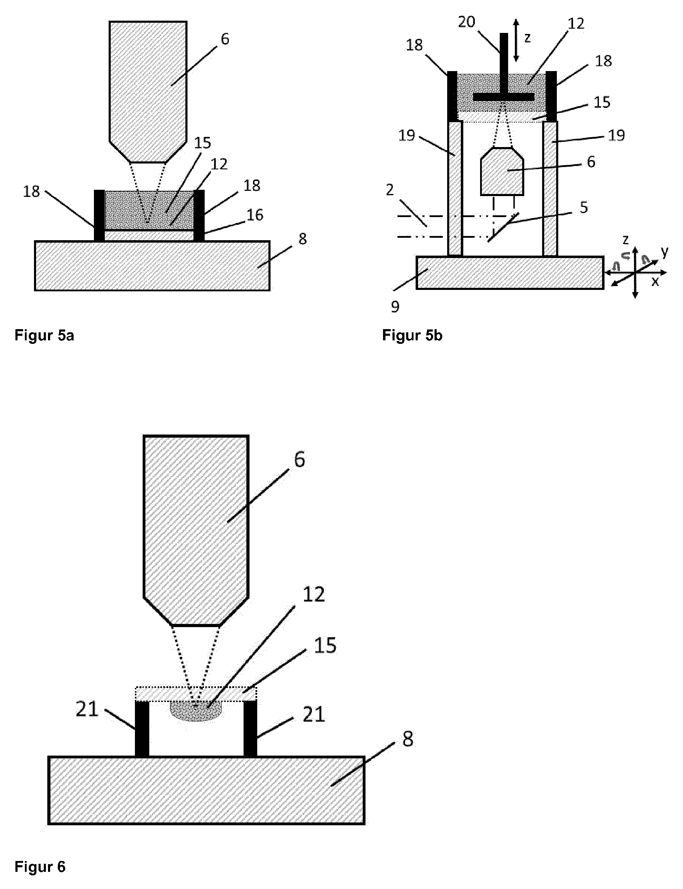

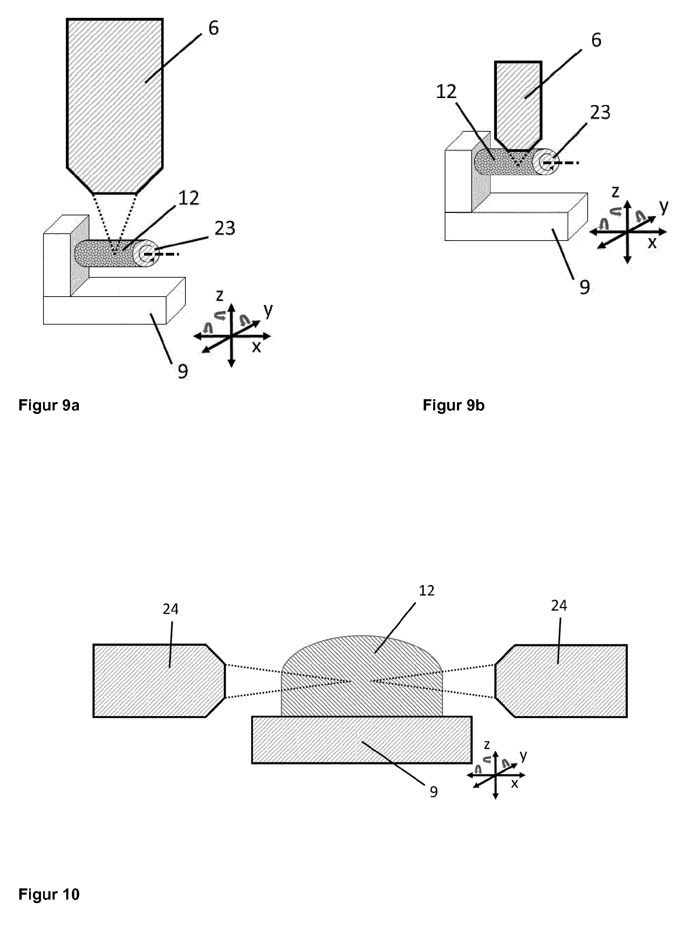

In einem Großteil der Ausgestaltungen der Erfindungen befindet sich die Fokussieroptik oberhalb des zu bearbeitenden Materials oder Körpers und damit auch oberhalb der Probenaufnahme. Sie kann jedoch auch unterhalb des zu bearbeitenden Materials oder Körpers oder seitlich hierzu, wie beispielhaft in Fig. 10 gezeigt, angeordnet sein. Wenn sie sich unterhalb befindet, kann die Probenaufnahme einen trägerartigen Aufbau für das Substrat oder den Körper umfassen, der innen Platz für die Fokussieroptik gewährt und dessen Konstruktion einen seitlichen Anschluss an die zugehörigen optischen Zuführungen erlaubt, wie z.B. in Fig. 5b) gezeigt, worin der trägerartige Aufbau aus Befestigungen 19 besteht. Der trägerartige Aufbau kann als Auflage für das Substrat oder den Körper dienen oder seinerseits eine Auflagefläche hierfür aufweisen, wobei ein Substrat dann transparent für die verwendete Lichtwellenlänge sein muss, wenn es sich zwischen der Fokussieroptik und dem zu bearbeitenden Material oder dem zu bearbeitenden Körper befindet.

Bei der Fokussieroptik kann es sich um ein Luftobjektiv handeln. Dieses kann gegenüber dem zu bearbeitenden Material dicht gestaltet sein, so dass es in letzteres eintauchen kann derart, dass eine direkte Grenzfläche Objektiv-Material ausgebildet wird. Alternativ kann ein (Öl-)Immersionsobjektiv genutzt werden, dessen Deckglas z.B. als Substrat verwendet werden kann. Alternativ wird die transparente Auflagefläche als 'Deckglas' genutzt und in das Material oberhalb der Auflagefläche fokussiert.

Im Falle eines Positioniersystems mit einem Träger, der drei translatorische und drei rotatorische Freiheitsgrade ermöglich, kann der Laserfokus bzw. können die Laserfoki mit der erfindungsgemäßen Vorrichtung immer senkrecht oder in einem gewünschten, beliebigen Winkel zur Substratoberfläche bzw. zu der virtuellen oder tatsächlichen Fläche positioniert werden, die gerade bearbeitet werden soll. Diese kann beliebig geformt, beispielsweise eben sein oder eine regelmäßige oder unregelmäßige Krümmung aufweisen und/oder unterschiedliche Komponenten, wie beispielsweise Kantenemitter, photonische integrierte Schaltkreise und/oder andere passive und aktive Elemente beinhalten, auch mikrofluidische Elemente und/oder auch elektronische Bauteile und/oder beliebige Kombinationen davon, wobei dies nicht einschränkend, sondern exemplarisch aufgeführt ist, da jede beliebige Anordnung von Bauteilen und/oder Komponenten mit jeder beliebigen Funktion (wie optisch, photonisch, elektrisch, elektronisch, magnetisch, piezoelektrisch, usw.) bearbeitet werden kann. Die Positionierung erfolgt durch eine Bewegung der oben beschriebenen Einrichtung (erster Träger zusammen mit zweitem Träger oder alleine) mit Probenaufnahme, ggf. ergänzt durch eine Bewegung der Fokussieroptik, die jedoch nicht zwingend ist. Sie kann in Form linearer und/oder rotatorischer Positionierung in und/oder um eine, zwei, drei oder mehr Achsen erfolgen. Insbesondere sind aufgrund der Eigenschaften des Positioniersystems und ganz besonders bei Verwendung eines ersten Trägers, wie oben definiert, beliebige Neigungswinkel und/oder Oberflächengeometrien bzw. Oberflächenmorphologien bzw. Oberflächentopologien bzw. Anordnungen möglich.

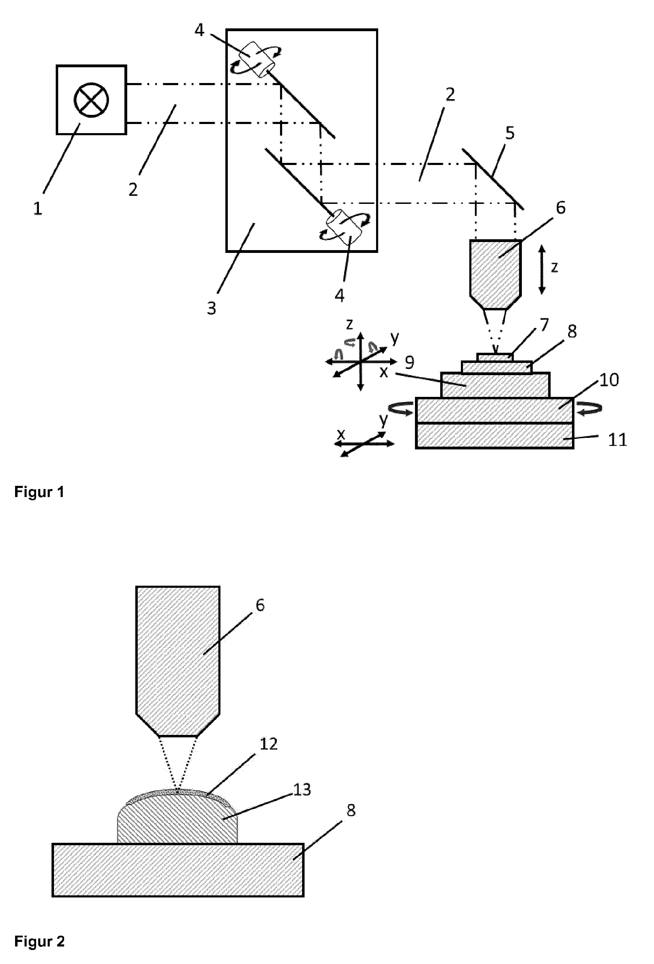

Eine spezifische Ausgestaltung der erfindungsgemäßen Vorrichtung ist in Fig. 1 zum besseren allgemeinen Verständnis der Erfindung schematisch dargestellt. Der nicht fokussierte Strahl 2 einer Laserquelle 1 wird über ein Galvo-Scanner-System mit drehbaren Umlenkspiegeln 4 auf einen Umlenkspiegel 5 geführt, der das Licht in die Fokussieroptik 6 einleitet. Diese Fokussieroptik ist in Z-Richtung verschiebbar. Der aus der Fokussieroptik austretende Strahl wird auf einen geeigneten Punkt oder Bereich des zu bearbeitenden Materials 7 fokussiert, das sich auf der Probenaufnahme, hier der Oberfläche eines Chucks 8, befindet. Dieser liegt auf einem ersten Träger (9), bei dem es sich um einen Hexapoden handeln kann, und dieser wiederum auf einem zweiten Träger, der hier aus einer um die Achse Z drehbaren Komponente 10 und einer in der X-Y-Ebene verschiebbaren Komponente 11 aufgebaut ist (es sollte klar sein, dass in Fig. 1 aus Anschaulichkeitsgründen viele der möglichen Komponenten in einer spezifischen Anordnung zueinander gezeigt sind. Dies bedeutet natürlich nicht, dass alle diese Komponenten vorhanden sein müssen. So ist es schon aus statischen Gründen günstiger, das Substrat unmittelbar auf dem Hexapoden zu befestigen, wenn dies möglich ist).

Als Substrat kann jede Struktur dienen, die mindestens eine sehr geringe Menge an bearbeitbarem Material, z.B. einen Tropfen davon oder eine ggf. auch sehr dünne Schicht davon, oder den zu bearbeitenden Körper halten kann. Das Substrat kann, muss aber nur in manchen Fällen, wie z.B. dem voranstehend beschriebenen, lichtdurchlässig sein, also z.B. aus einem Glas bestehen. Stattdessen sind selbstverständlich andere Materialien als Substrat geeignet, z.B. Metalle. Um die Vielfalt und Variabilität der einsetzbaren Substrate zu demonstrieren, seien nachstehend einige Beispiele genannt, die keinesfalls einschränkend verstanden werden dürfen.

In einer ersten Variante handelt es sich z.B. um ein flächiges Substrat ohne Seitenwände. Dieses Substrat kann mit einer Schicht aus zu bearbeitendem, beispielsweise zu verfestigendem Material belegt sein, die mit Hilfe des erfindungsgemäßen Verfahren strukturiert verfestigt oder anderweitig bearbeitet und auf dem Substrat verbleiben soll. Daher eignet sich die Erfindung z.B. zur Modifikation von Oberflächen. So kann es sich bei dem Substrat beispielsweise um eine Linse oder einen Hohlspiegel oder einen mit Noppen oder anderen vorgegebenen Strukturierungen versehenen Körper oder ein solches Gefäß oder einen solchen Hohlkörper handeln. Figur 2 zeigt eine Ausgestaltung, die sich zur Verdeutlichung dieser Variante eignet. In dieser Figur umfasst das Positioniersystem einen Chuck 8, dessen Oberfläche die Probenaufnahme darstellt und auf dem das Substrat aufliegt. Es kann sich bei dem Substrat beispielsweise um eine Linse handeln, auf der sich eine Schicht 12 eines zu verfestigenden oder anderweitig zu bearbeitenden Materials befindet.

Alternativ kann eine kleine Menge, z.B. ein Tropfen, oder eine flüssige oder pastöse Schicht auf das Substrat aufgebracht werden, in dem/der ausgehend von der Substratoberfläche eine Bearbeitung stattfindet, beispielsweise eine dreidimensionale Struktur verfestigt wird, die anschließend von nicht-verfestigtem umgebendem Material befreit, also "entwickelt" wird. Zur Ablösung vom Substrat kann dieses in solchen Fällen mit einer Opferschicht oder einer Schicht belegt sein, auf der das verfestigte Material nur schwach haftet. In einem derartigen Tropfen oder in einer derartigen Schicht kann bei Einsatz geeigneter verfestigbarer Materialien auch eine dreidimensionale Struktur ausgebildet werden, die durch eine anschließende Behandlung löslicher wird als der nicht von der 2- oder Mehr-Photonen-Polymerisation betroffene Bereich. In dieser Ausgestaltung kann im Falle der Nutzung eines Öl-Immersionsobjektivs dessen Deckglas als Substrat dienen.

Wird mit einer kleinen Menge an zu verfestigendem Material gearbeitet, dann lassen sich die Meniskuseigenschaften und damit die Außenform des durch Kohäsion aneinander haftenden Materials durch Oberflächenmodifikation und Funktionalisierung der Oberflächen zur Einstellung der Grenzflächenenergien steuern. Hierfür können die Materialeigenschaften eingestellt werden, z.B. durch Einführung hydrophober oder hydrophiler Gruppen in das polymerisierbare Material.

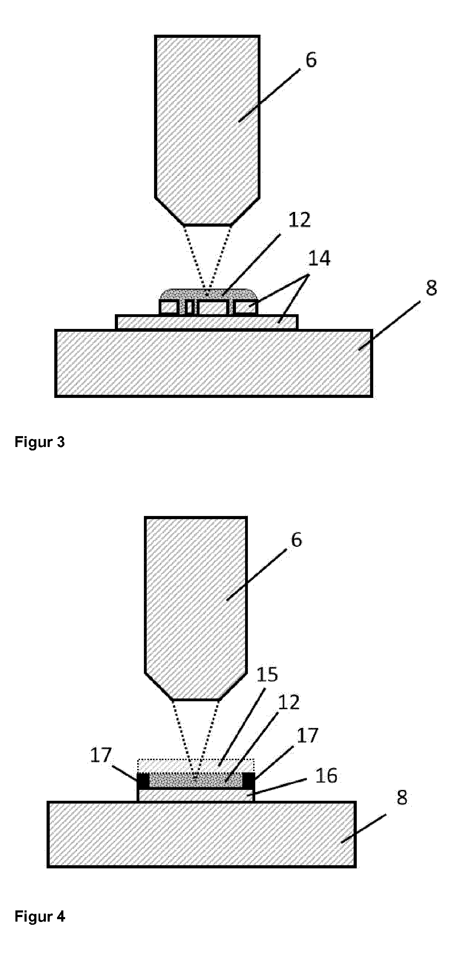

In einer zweiten Variante handelt es sich bei dem Substrat um ein in der Herstellung befindliches Bauteil, beispielsweise ein optisches oder optoelektronisches Bauteil oder einen photonischen Chip oder einen photonisch integrierten Schaltkreis (PIC: Photonic Integrated Circuit) oder eine (teil-)bestückte oder unbestückte Leiterplatte oder allgemein ein Bauteil mit aktiven und/oder passiven Bauelementen, wie Aktoren, Sensoren oder Spiegeln oder anderen Komponenten, wie beispielsweise Glasfasern oder Glasfaserbändchen. Wenn die Bauelemente klein genug sind oder deren Abstand voneinander im Bauteil klein genug ist, genügt häufig wiederum ein einziger Tropfen an zu bearbeitendem, insbesondere zu verfestigendem Material, der auf eine Fläche oder in eine Kavität (sofern vorhanden) des Bauteils aufgebracht werden kann. Es lassen sich jedoch auch beliebige, aus dem Stand der Technik bekannte Beschichtungsprozesse anwenden, mit oder ohne äußere Begrenzung des zu beschichtenden Bereichs. Mit Hilfe des erfindungsgemäßen Verfahrens wird/werden sodann eine oder mehrere vorzugsweise optische Komponenten für dieses Bauelement strukturiert, ausgewählt z.B. unter Wellenleitern, Kollimatoren, Mikrolinsen, Gittern, diffraktiven optischen Elementen, Kombinationen aus refraktiven und diffraktiven Elementen und Phasenelementen, die direkt auf dem Boden des Bauelements oder auf einer im Bauelement bereits vorhandenen Struktur ausgebildet wird/werden. Das verfestigbare Material kann dabei so ausgewählt werden, dass die erfindungsgemäß strukturierte Komponente entweder nach der Strukturierung von restlichem Material befreit wird und/oder dass das gesamte verfestigbare Material vorher durch Licht und/oder Wärmebehandlung vorvernetzt wird und/oder dass das gesamte verfestigbare Material gemessen an seinem möglichen maximalen Umsatz der vernetzbaren chemischen Gruppen vollständig vorvernetzt wird und/oder dass das gesamte verfestigbare Material anschließend durch Wärme oder Flutlicht nachverfestigt wird. Wie aus dem Stand der Technik bekannt, besitzt in solchen Fällen die mit Hilfe von TPA/MPA strukturierte Komponente eine andere Sekundär- oder Tertiärstruktur, so dass sie sich physikalisch (z.B. durch ihre Brechzahl und/oder ihre mechanischen und/oder chemischen und/oder dielektrischen und/oder magnetischen Eigenschaften) von der durch Wärme oder Flutlicht gehärteten Umgebung unterscheidet. Die zweite Variante ist in Fig. 3 verdeutlicht, wobei sowohl das Bauteil als auch darauf befindliche Bauelemente oder Komponenten (also das gesamte sog. Assembly) mit der Bezugsziffer 14 bezeichnet sind.

In einer spezifischen Ausführungsform dieser Variante wird ein Wellenleiter strukturiert und anschließend von dem umgebenden Material befreit ("entwickelt"), worauf ein von diesem Material verschiedenes Material (fest, flüssig oder auch gasförmig) eingebracht wird, das als Cladding dient und dessen Brechungsindex vorzugsweise so gewählt ist, dass die Brechzahldifferenz zwischen dem Wellenleiter und dem Cladding höher ist als diejenige zwischen dem Wellenleiter und dem Material, aus dem er strukturiert wurde. Auf diese Weise lassen sich hohe NA bei gleichzeitiger Ausnutzung der 3D-Fähigkeit herstellen.

In einer dritten Variante wird verfestigbares Material oder Material, dessen Bindungen durch den TPA/MPA-Prozess gebrochen werden können, zwischen zwei Substraten angeordnet, von denen das auf der Probenaufnahme angeordnete Substrat beliebiger Natur sein kann, z.B. wie in den beiden ersten Varianten erläutert, während das zweite Substrat lichtdurchlässig sein muss. Die Bestrahlung kann dabei von oben oder von unten oder von beiden Seiten durchgeführt werden, wobei bei einer Bestrahlung von unten und oben natürlich zwei transparente Substrate bzw. Träger vorhanden sind. Figur 4 zeigt eine Ausgestaltung, die sich auf diese Variante lesen lässt. Dabei wird das zu bearbeitende Material 12 zwischen zwei Substraten 15, 16 angeordnet, deren oberes lichtdurchlässig sein muss. Fakultativ vorzusehende Abstandshalter 17 sorgen für einen gleichmäßigen und ggf. gleichbleibenden Abstand der Substrate voneinander. Natürlich lassen sich alternative Verfahren mit einem solchen Aufbau durchführen, beispielsweise Polymerisationsreaktionen in einem (z.B. flüssigen) Material zwischen den beiden zwei Substraten.

In einer vierten Variante wird ein relativ großer Körper mit Hilfe der 2PP-Strukturierung erzeugt. Hierfür kann das Substrat als Materialbehälter für ein Bad aus dem verfestigbaren Material ausgebildet sein, wie beispielsweise in der obengenannten WO 2011/141521 A1 gezeigt, oder das Material kann als Meniskus zwischen einem beliebig geformten Substrat und einer Fokussieroptik, wie beispielsweise einem Mikroskopobjektiv, gehalten werden. Die Gestalt des Meniskus' kann durch Einbringen geeigneter Oberflächenfunktionalitäten in das verwendete Material noch weiter verbessert werden. Dies gelingt beispielsweise durch die oben beschriebene Modifizierung der hydrophoben/hydrophilen Materialeigenschaften. Damit immer ausreichend zu belichtendes Material zwischen Fokussieroptik und Substrat vorhanden ist, wie es beispielsweise für das Fertigen großer Strukturen notwendig sein könnte, kann das Material z.B. durch einen Dispenser, z.B. mit einer (Mikro)Pumpe und/oder einem mikrofluidischen Element, nachgeliefert werden. Zwei verschiedene Ausgestaltungen dieser Variante sind in den Figuren 5a und 5b gezeigt. Während das Material 12 in der ersten dieser Ausgestaltungen von oben belichtet wird, erfolgt die Belichtung in der zweiten Ausgestaltung von unten, und zwar durch den transparenten Boden 15 des Materialbehälters 15, 18 (der hier als Substrat fungiert) hindurch, wobei im Bad ein Träger vorhanden ist, an dem die zu verfestigende Struktur ankoppeln kann. Ein Träger kann natürlich auch eingesetzt werden, wenn von oben belichtet wird. Bei Bedarf kann die Fokussieroptik dicht gegenüber dem Material ausgestaltet sein und in das Bad eintauchen.

In einer fünften Variante ist das Substrat an Abstandshaltern befestigt, die sich auf der Probenaufnahme oder dem Chuck o.ä. befinden derart, dass ein Zwischenraum zwischen dem Substrat und der Halterung gebildet ist, an dem z.B. ein Tropfen aus zu verfestigendem Material hängt, der mit Hilfe des Lasers und der Fokussieroptik durch das Substrat hindurch mit der Lichtstrahlung angesteuert wird. In diesem Tropfen kann eine dreidimensionale Struktur ausgebildet werden, wie oben für die erste Variante beschrieben. Auch hier kann die Tropfenform, wie voranstehend beschrieben, beeinflusst werden. Diese Variante kann auch für Positivresiste genutzt werden. Dabei werden die Strukturen durch Bindungsbruch in eine am Substrat befindliche Beschichtung geschrieben. Danach kann entwickelt und z.B. eine Metallisierung aufgebracht und das nicht belichtete Material durch einen Lift-off entfernt werden. Die Variante ist in Fig. 6 gezeigt, worin Abstandshalter 21 auf einem Chuck 8 befestigt sind und das Substrat 15 tragen, an dem ein Tropfen 12 des zu strukturierenden Materials hängt.

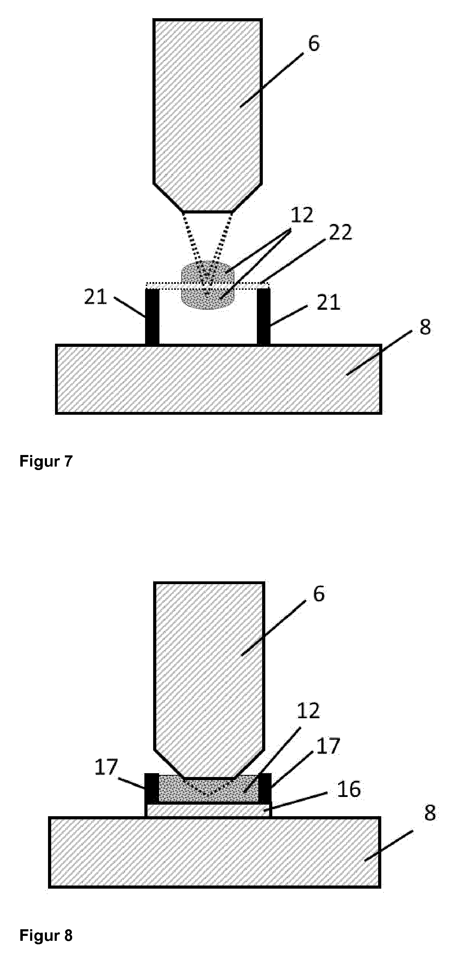

In einer sechsten Variante umfasst das Substrat einen lichtdurchlässigen Bereich, der beidseitig mit zu bearbeitendem, insbesondere zu verfestigendem Material versehen ist. Wenn dieser Bereich ausreichend dünn ist, kann bei geeigneter Auswahl der Fokussieroptik (z.B. einer niedrigen NA) eine gleichzeitige Verfestigung der Bereiche beidseits der Oberflächen des lichtdurchlässigen Bereichs bewirkt werden, da, wie oben erwähnt, für sehr niedrige NA und kleine Vergrößerungen Voxel mit Längen von bis zu ca. 100 µm oder ggf. noch mehr verfestigt werden können, wenn das Zentrum der Voxel innerhalb des lichtdurchlässigen Bereichs liegt. Auf diese Weise lassen sich geeignete Materialien, z.B. dünne Gläser oder Glaskeramiken oder andere transparente Materialien, ggf. auch in Form von Rohren, einsetzen, die beidseitig beschichtet werden können. Hierfür kann ggf. eine Halterung eingesetzt werden, die das beidseitige Beschichten des Substrats mit dem flüssigen oder pastösen Material erlaubt, ohne dass die Vorrichtung verschmutzt. Bei Einsatz von Objektiven mit sehr hoher NA lassen sich so insbesondere auch Strukturen im unteren Mikrometerbereich oder auch Nanostrukturen von bis unterhalb 100 nm auf beiden Seiten eines dünnen, transparenten Substrats beliebiger Form erzielen, sofern das Material auch bei Vernetzung bei Intensitäten innerhalb des FWHM (Full Width Half Maximum) oder etwas darunter liegt. Figur 7 zeigt diese Variante, die im speziellen Fall außerdem die Merkmale der fünften Variante, also Abstandshalter 21 auf einem Chuck 8, aufweist. Man erkennt, dass sich zu verfestigendes Material 12 - hier tropfenförmig - auf dem sehr dünnen, transparenten Substrat 22 befindet, bei dem es sich auch um ein Gefäß oder ein Rohr handeln kann. Selbstverständlich kann die Belichtung stattdessen oder zusätzlich mit einer unterseitigen Fokussieroptik durchgeführt werden, oder die Belichtung erfolgt ggf. (nur oder zusätzlich) von der Seite. Damit kann man, wenn man in das transparente Substrat fokussiert, eine kleinere Menge an Material belichten, da der Voxel in X-Y-Richtung kleiner als in Z-Richtung ist.

In einer siebten Variante taucht die Fokussieroptik in das auf dem Substrat befindliche zu verfestigende Material ein, wie für die zweite Ausgestaltung der WO 2011/141521 A1 beschrieben, wobei das Substrat jedoch anders als in der WO 2011/141521 A1 beschrieben eine beliebige Form haben kann, z.B. eine Form wie in einer der Varianten eins, zwei und sechs. Figur 8 zeigt eine Ausgestaltung mit flüssigem oder pastösem Material 12, das sich auf einem Substrat 16 befindet und optional von Wänden 17 gehalten werden kann.

Das Substrat kann selbstverständlich in allen vorgenannten Varianten in beliebiger Ausrichtung, z.B. auch schräg, auf der Tragefläche angeordnet werden; eine Vorzugsrichtung in z.B. X, Y oder Z ist nicht erforderlich.

In einer achten Variante ist das Substrat um eine X-Achse drehbar z.B. über einem Materialbad angeordnet, in das es eintaucht oder eingetaucht werden kann. Seine Lagerung erfolgt über die X-Achse, die an eine Probenaufnahme einer Vorrichtung angekoppelt ist, die drei translatorische und drei rotatorische Bewegungen ausführen kann. Bei dieser kann es sich um den ersten Träger der erfindungsgemäßen Vorrichtung handeln. Die Drehbewegung wird vom seitlich angebrachten Träger initiiert. Diese Variante ist in den Fig. 9a und 9b gezeigt, wobei in Fig. 9b die Fokussieroptik in das zu verfestigende Material eintaucht. Diese Konstruktion kann auch genutzt werden, um ein dünnes Substrat beidseitig zu bearbeiten.

In einer neunten Variante wird in Fig. 10 exemplarisch gezeigt, dass die Fokussier-Optik(en) auch seitlich angebracht werden können und auf diese Weise das Material strukturieren. Zusätzlich kann von oben und/oder unten strukturiert werden.

Je nach verwendeter Optik und Material können, wie oben erwähnt, in einem zu verfestigenden Material Struktureinheiten (Voxel) von weniger als 100 nm bis hin zu 100 µm erzeugt werden. Durch Anpassung der Laserintensität und des Schwellwertprozesses können theoretisch infinitesimal kleine Volumenelemente kreiert werden. Durch eine Kombination aus refraktiver und diffraktiver Optik kann der optische Weg der Laserpulse durch die Optik bzw. der Lichtweg durch die Optik kurz gehalten und es können Abbildungsfehler reduziert werden. Umgekehrt können für bestimmte Strukturierungsaufgaben auch gezielt Abbildungsfehler während der Strukturierung eingebracht werden. Die erzeugten Voxel können sich mehr oder weniger überlappen (neben dem klassischen Voxel-an-Voxel-Ansatz kann das Verfahren unter mit dem ersten Träger bewirktem Bewegen des fokalen Volumens in drei Raumrichtungen und mit Hilfe des ersten Trägers möglicher beliebige Verkippung / Form unter einer Art "Dauerpulsmodus" arbeiten. Bei gut verstandener Licht-Materie-Wechselwirkung lässt sich das Vernetzungsergebnis oder ein vergleichbares Ergebnis bei anderen als Vernetzungsreaktionen sehr gut beeinflussen und bilden in ihrer Gesamtheit die herzustellende ein- bis dreidimensionale Struktur. Je nach Größe der erzeugten Voxel ist es möglich, die Struktur mit einer beliebig skalierbaren Porosität zu versehen. Dieses ist insbesondere zur Erzeugung von Gerüststrukturen zur Anregung von Zellwachstum ("Scaffolds") von Bedeutung. Solche Gerüststrukturen können mit Vorteil eine Porenstruktur im Bereich von 10 nm bis 10 mm, bevorzugt von 1 µm bis 5 mm besitzen, wobei eine Porosität auf Nanometerskala (0,5 bis 10 nm) durch die Licht-Materie-Wechselwirkung für unterschiedlich vernetzende Materialien, wie beispielsweise Mischungen von Acrylaten mit (Meth-)acrylaten, Epoxiden mit (Meth)-Acrylaten, Styrylen mit (Meth-)Acrylaten und/oder Epoxiden eingestellt werden kann. Porosität kann auch durch Zusatz von Lösemitteln oder den Zusatz von (funktionalisierten) Nano- oder Mikropartikeln beeinflusst werden. Ebenso können alle Varianten mit Materialien, die Norbonengruppen enthalten, in beliebigen Verhältnissen gemischt werden, wobei dreierlei Mischungen verwendet werden: (1) solche, die physikalisch gemischt werden; (2) solche, die auf molekularer Ebene durch eine chemische Synthese mit unterschiedlichen Gruppen, die beispielsweise kovalent und/oder durch Wasserstoffbrückenbindungen und/oder durch van der Waals-Bindungen angebunden sein können, hergestellt werden; (3) solche, die durch physikalisches Mischen von Materialien aus (1) und (2) hergestellt werden. Dabei lassen sich auch geeignet modifizierte Nanopartikel oder Gemische aus Nano- und Mikropartikeln einbringen, wie in WO 2012/097836 A1 beschrieben.

Die strukturierende Belichtung eines bereits (teilweise oder sogar schon vollständig) verfestigten Material mit TPA/MPA oder das (teilweise oder vollständige) Verfestigen eines strukturiert mit TPA/MPA belichteten Materials wiederum kann genutzt werden, um in ein- und demselben Körper aus ein- und demselben Material Bereiche mit unterschiedlichen chemischen und/oder physikalischen Eigenschaften, z.B. unterschiedlicher Sekundär- oder Tertiärstruktur, zu erzeugen, wobei diese unterschiedlichen physikalischen Eigenschaften, z.B. eine variierende Brechzahl oder variierende mechanische Eigenschaften sein können. Dabei ist es unerheblich, ob die chemischen Funktionalitäten chemisch, beispielsweise kovalent, angebunden sind oder es sich um eine physikalisch hergestellte Mischung handelt.

Bei einer Einleitung von Laserstrahlung durch ein (ggf.) zweites, lichtdurchlässiges Substrat hindurch ist es von besonderem Vorteil, dass es nicht zu einem Kontakt zwischen Optik und zu verfestigendem Material kommt. Hierdurch ist ein schnelles Verfahren und Positionieren der Optik möglich. Es werden keine Turbulenzen im Material erzeugt und es besteht ein geringerer Widerstand als bei der Positionierung einer eingetauchten Optik. Des Weiteren muss die Optik nicht gegenüber dem zu verfestigenden Material abgedichtet sein.

Sollen Metalle strukturiert werden oder ist in anderen erfindungsgemäß einsetzbaren Prozessen die Entwicklung von Dämpfen oder Gasen zu befürchten, wird vorzugsweise ein Aufbau verwendet, der die Optik vor schädlicher Redeposition aus dem Prozess schützt, indem beispielsweise ein Glas vor das Objektiv gesetzt wird, die gesamte Optik gehaust wird und/oder auch ein Gasstrom aus einem Trägergas, wie z.B. trockenem Stickstoff oder trockenem Argon oder trockener Druckluft oder Gemischen unterschiedlicher Gase, in das Bearbeitungsvolumen eingebracht wird, um aus dem Prozess entstehende Substanzen durch beispielsweise Absaugung aus dem Reaktionsbereich zu entfernen. Da Kontakt zwischen der Optik und dem zu verfestigenden Material nicht zustande kommt, können auch aggressive Materialien, die die Optik beschädigen würden, verarbeitet werden.

Im Falle einer in das Material eintauchbaren Fokussieroptik bildet diese selbst eine definierte optische Grenzfläche für den in das zu verfestigende Material eintretenden Laserstrahl aus. Anders als bei der vorgenannten Ausführungsform kann die Verfestigung an jeder beliebigen Stelle im zu verfestigenden Material erfolgen, ohne dass eine zusätzliche positionierbare Trägereinheit verwendet werden muss, da die Optik in gewünschter Weise im Material positioniert sowie nahezu beliebig tief eingetaucht werden kann und der Ort der Verfestigung nicht durch den Arbeitsabstand der Optik beschränkt ist.

Aus den voranstehenden Erläuterungen wird deutlich, dass die erfindungsgemäße Vorrichtung wie in ihren verschiedenen Ausführungsformen beschrieben und nachstehend beansprucht in allen lasergestützten Verfahren eingesetzt werden kann, in denen ein an einem Substrat anhaftendes Material oder ein substratassoziierter oder substratfreier Körper oder dessen Oberfläche bearbeitet werden soll, wobei das lasergestützte Verfahren insbesondere ein solches ist, mit dem sich TPA/MPA ausführen lässt, und/oder bei dem mit einem gepulsten Laser eine Behandlung stattfindet. Einige solche Verfahren ("speziellere Verfahren") sollen beispielhaft nachstehend unter Bezugnahme auf die Figuren näher erläutert werden. Dabei kann die erfindungsgemäße Vorrichtung in jeder beliebigen der genannten Ausführungsformen eingesetzt werden, es sei denn, dass spezifische Anordnungen der Vorrichtung explizit genannt werden.

Unter anderem umfassen diese Verfahren solche zur Modifikation einer Oberfläche eines Substrates (13), die ein zu bearbeitendes, flüssiges oder festes Material (12) aufweist, oder zum Bearbeiten eines Tropfens oder einer flüssigen oder pastösen Schicht (12) auf oder an einem Substrat (14), wobei das Substrat auf der Probenaufnahme einer erfindungsgemäßen Vorrichtung aufliegt oder daran befestigt ist. Bei dem Substrat kann es sich in dieser Variante der Verfahren um einen in der Optik einsetzbaren Gegenstand, vorzugsweise eine Linse oder einen Hohlspiegel, oder um einen mit vorgegebenen Strukturierungen versehenen Körper oder ein solches Gefäß oder einen solchen Hohlkörper oder um ein optisches, elektrisches oder optoelektronisches Bauteil oder Bauelement handeln. Beispielsweise kann ein Tropfen aus zu bearbeitendem Material (12) an einem Substrat (15) haften und mit Hilfe der Fokussieroptik strukturiert belichtet werden, wobei dann, wenn sich der Tropfen unterhalb des Substrats befindet, die Belichtung entweder durch das Substrat hindurch erfolgt, wobei das Substrat für die Strahlung der Laserquelle durchlässig ist, oder wobei die Vorrichtung die Gestaltung des Anspruchs 13 aufweist, worin die Fokussieroptik in unmittelbarem Kontakt mit dem zu bearbeitenden Material stehen kann.

Weitere Verfahren sind solche zur Bearbeitung eines Negativresists, eines Positivresists, eines E-Beam-Resists (z.B. aus PMMA) (12) und dergleichen, der zwischen zwei Substraten angeordnet ist, wobei eines dieser Substrate auf der Probenaufnahme einer erfindungsgemäßen Vorrichtung aufliegt oder daran befestigt ist und das andere, durch welches fokussiert wird, transparent oder opak ist.

Nochmals weitere Verfahren sind auf die Herstellung eines Körpers innerhalb eines Badbehälters mit flüssigem oder pastösem, verfestigbarem Material gerichtet, wobei der Badbehälter auf der Probenaufnahme einer erfindungsgemäßen Vorrichtung angeordnet ist (aufliegt), in der sich die Fokussieroptik (6) oberhalb der Probenaufnahme befindet, derart, dass sie sich im Betrieb der Vorrichtung oberhalb des von der Probenaufnahme gehaltenen Substrats (7) oder Körpers (7) befindet, oder wobei der Körper ausgehend von einem in dem Material befindlichen Träger verfestigt wird, wobei dieser Träger an der Probenaufnahme einer Vorrichtung befestigt ist, die um eine in einer Ebene angeordnete Achse drehbar angeordnet ist, wobei diese Achse seitlich an eine Komponente des Positioniersystems angekoppelt und vorzugsweise lateral in einer Richtung verschiebbar ist, die einen rechten Winkel mit der genannten Achse bildet, wobei der Träger vorzugsweise während des Verfahrens in das verfestigbare Material eintaucht.

Nochmals weitere Verfahren sind auf das Bearbeiten eines Körpers (eines dreidimensionalen Körpers, aber auch z.B. einer Folie) oder eines flüssigen oder pastösen Materials gerichtet, das sich in einem Badbehälter mit Seitenwänden (18) oder auf oder an oder unter einem beliebig geformten Substrat (15) befindet, wobei sich der Körper oder der Badbehälter oder das Substrat an oder auf der Probenaufnahme einer erfindungsgemäßen Vorrichtung befindet und sich die Fokussieroptik (6) während des Verfahrens unterhalb des von der Probenaufnahme gehaltenen Substrats (7) oder Körpers (7) befindet, wobei die Probenaufnahme aus einer Befestigung (19) besteht oder diese umfasst, die eine vom Positioniersystem (9, 10, 11) beabstandete Position des zu bearbeitenden Materials oder Körpers ermöglicht und freien Raum aufweist, um die Fokussieoptik aufzunehmen.

Nochmals weitere Verfahren sind auf das Bearbeiten eines an einem Substrat anhaftenden Materials gerichtet, wobei sich das Material in einem Meniskus zwischen der unterhalb der Probenaufnahme befindlichen Fokussieroptik einer erfindungsgemäßen Vorrichtung und dem Substrat befindet, wobei das Substrat auf der Probenaufnahme aufliegt oder an dieser befestigt ist oder anhaftet.

Nochmals weitere Verfahren sind auf das Bearbeiten eines zumindest teilweise dünnwandigen, lichtdurchlässigen Körpers gerichtet, wobei der Körper derart an oder auf der Probenaufnahme einer erfindungsgemäßen Vorrichtung, in der sich die Fokussieroptik (6) vorzugsweise oberhalb der Probenaufnahme befindet, derart, dass Oberflächen auf beiden Seiten der dünnen Wand des Körpers gleichzeitig bearbeitet werden können.

Nochmals weitere Verfahren sind auf das Bearbeiten eines gläsernen oder eines metallischen Körpers oder eines Körpers, der metallische oder gläserne Komponenten unter Verwendung einer erfindungsgemäßen Vorrichtung gerichtet, wobei der Körper entweder direkt auf der Probenaufnahme aufliegt oder auf oder an dieser befestigt ist oder worin der Körper sich auf einem Substrat befindet, das an oder auf der Probenaufnahme befestigt ist. Auch dieser Körper kann selbstverständlich dreidimensional oder folienförmig sein.

Das zu bearbeitende Material kann, wie sich aus den vorstehenden Erläuterungen ergibt, in einer Reihe von Ausführungsformen ein zu verfestigendes Material sein. Ein zu verfestigendes Material im Sinne der Erfindung ist ein organisches Material oder ein anorganisch-organisches Hybridmaterial, insbesondere ein organopolysiloxanhaltiges Material, das sich jeweils photochemisch verfestigen lässt. Das zu verfestigende Material kann insbesondere ein beispielsweise mit Nano- oder Mikropartikeln gefülltes oder ein ungefülltes Material sein. Gefüllte Materialien weisen bestimmte unter Umständen ungebundene Additiv-Materialien auf, die dem Material bestimmte gewünschte Eigenschaften, beispielsweise optische, elektrooptische, elektrische, mechanische und/oder auch magnetische Eigenschaften verleihen können.

Das zu verfestigende Material wird häufig lösemittelfrei und bevorzugt lösemittelarm (z.B. mit nur wenigen, meist 1-3 Gew.-% Lösemittel, die sich nach der Herstellung eines beispielsweise anorganisch-organischen Materials nur schlecht oder gar nicht aus diesem entfernen lassen) verarbeitet. Wird kein Lösemittel verwendet, können Materialien je nach ihrer chemischen Struktur eine sehr hohe Viskosität besitzen. Viele mit TPA/MPA verfestigbare Materialien sind jedoch auch ohne Lösungsmittel flüssig oder nur wenig pastös. Das Arbeiten mit einem lösemittelfreien Material hat eine Reihe von Vorteilen. So enthalten die damit hergestellten Strukturen in der Regel keine kleinmolekularen, möglicherweise toxischen oder sonstwie bedenklichen Verbindungen.

Soll der fertig verfestigte Formkörper vom Substrat getrennt werden (Negativ-Resist-Verfahren), kann letzteres ggf. in bekannter Weise derart (durch monomolekulare oder dickere Schichten) funktionalisiert sein, dass die Ablösung während des Entwicklungsprozesses mit Hilfe eines Lösungsmittels oder durch "Abheben" des Struktur mittels einer Pinzette oder anderen, speziell angeordneten Vorrichtung (z.B. eines Messers) möglich ist. Auch kann eine Opferschicht auf das Substrat aufgebracht werden, auf der der verfestigte Formkörper gut haftet, sich aber im Entwicklungsprozess (dem Befreien von anhaftendem Badmaterial) auflöst, so dass sich die erzeugte Struktur vom Substrat abhebt.

Alternativ können mit Hilfe von TPA/MPA chemische Bindungen in einem zu bearbeitenden Material gelöst und die dadurch löslicher gemachten Bereiche anschließend ausgewaschen werden (Positiv-Resist-Verfahren). Dieses Material ist vorzugsweise meist fest und liegt dann in Form eines Körpers vor.

Sollen mit der erfindungsgemäßen Vorrichtung Gläser oder Glaskeramiken oder andere transparente Körper bearbeitet werden, so werden durch die TPA/MPA im Fokusbereich beispielsweise Redox-Prozesse oder Umstrukturierungsprozesse ausgelöst, die eine Veränderung der Löslichkeit des Glases bzw. der Glaskeramik bzw. des anderen transparenten Körpers bewirken. Die stärker löslichen Komponenten können sodann ausgewaschen oder ausgeätzt werden, bei Glas/Glaskeramik beispielsweise mit HF, NH₄F oder Mischungen davon.

Für die Bearbeitung von Metallen kommen metallische oder metallbeschichtete Formkörper oder metallische Oberflächen auf einem nichtmetallischen Substrat zum Einsatz. Im Fokusbereich des Kurzpulslasers wird Metall verflüssigt, verdampft oder sublimiert.

In einer Ausgestaltungsform weist eine erfindungsgemäße Vorrichtung eine Optik zur räumlichen Aufteilung des Laserstrahls und Erzeugung wenigstens zweier oder mehr räumlich voneinander beabstandeter Laserfoki oder Intensitätsmaxima auf, was im Nachfolgenden als Parallelisierung bezeichnet wird. Hierdurch kann die Strahlungsenergie des Lasers räumlich gleichzeitig auf zwei oder mehrere Voxel gerichtet werden, so dass eine Verfestigung gleichzeitig an zwei oder mehreren Stellen auftritt. Relativ große Strukturen und Formkörper können so in kurzer Zeit erzeugt werden. Bei gleichzeitiger Erzeugung von n Voxeln lässt sich damit die Produktionszeit der herzustellenden Strukturen abhängig vom zu produzierenden Element um den Faktor n beschleunigen. Dieser Faktor n entspricht mindestens der Anzahl der durch Strahlaufteilung erzeugten Intensitätsmaxima bzw. Laserfoki, durch die eine Mehrphotonenpolymerisation hervorgerufen wird.

Mittels Parallelisierung ermöglicht die Erfindung nicht nur eine parallele Erzeugung von Voxeln eines einzigen Funktionselements, sondern auch eine parallele Erzeugung zweier oder mehrerer Funktionselemente. (Unter "Funktionselement" soll hier eine beliebige funktionelle Struktur verstanden werden, d.h. ein Element, das eine irgendwie geartete (optische oder andere) Funktion aufweist. Ein sehr einfaches Beispiel ist eine Mikrolinse.) Eine einzelne Struktur kann gleichzeitig über mehrere Brennpunkte oder mehrere Strukturen können gleichzeitig über jeweils einen oder mehrere Brennpunkte erzeugt werden. Dabei können eine oder mehrere Optiken verwendet werden, um n Foki zu erzeugen. Es ist möglich, mehrere Strukturen auf demselben Substrat zu fertigen, als auch für jede Struktur ein eigenes Substrat zu wählen.

Die Parallelisierung kann weiterhin durch Strahlformung oder Aufteilen eines Laserstrahls in mehrere Teilstrahlen erfolgen, die dann jeweils fokussiert werden und im Material an mehreren Stellen gleichzeitig Voxel verfestigen. Hierfür kann beispielsweise eine Amplitudenmaske verwendet werden, die in den Strahlengang gebracht wird und im Fernfeld des Strahls ein Beugungsmuster erzeugt. Daneben kann ein Mikrolinsenarray, eine Axikon Linse beispielsweise zur Erzeugung einer ringförmigen Brennebene oder ein elektrisch ansteuerbarer räumlicher Lichtmodulator als dynamisch variable Phasenmaske eingesetzt werden, der eine gezielte Verteilung der Lichtintensität in mehrere Brennpunkte und somit eine Teil-Parallelisierung des Strukturierungsprozesses bewirkt. Zusätzlich können die Brennpunkte durch gezielte dynamische Modulation der Phase im Raum bewegt werden, wodurch auf mechanische Verschiebeeinheiten verzichtet werden kann.

In einer anderen Ausführung wird die parallele Herstellung der Strukturen durch DLP (Digital Light Processing) eine im Stand der Technik bekannte Projektionstechnik, erzeugt. Bei dieser Technik werden Bilder erzeugt, indem ein digitales Bild auf einen Lichtstrahl aufmoduliert wird. Dabei wird der Lichtstrahl durch eine rechteckige Anordnung von beweglichen Mikrospiegeln in Pixel zerlegt und dann pixelweise entweder in den Projektionsweg hinein oder aus dem Projektionsweg hinaus reflektiert. Das Herzstück dieser Technik, das Bauteil, das die rechteckige Anordnung (Matrix) von Spiegeln und deren Ansteuerungstechnik enthält, wird als DMD - Digital Micromirror Device (zu Deutsch etwa "Digitale Mikrospiegel-Einheit") bezeichnet.

Im Gegensatz zu anderen Verfahren, bei denen ein reales Bild oder ein realer Gegenstand unmittelbar auf optischem Wege abgebildet wird, wird hier- ähnlich wie bei der Laserprojektion - das Bild optisch erst innerhalb des Projektionsweges erzeugt. Deshalb handelt es sich streng genommen nicht um eine Projektion, wie sie in der physikalischen Optik definiert wird. So lassen sich ebenfalls gleichzeitig entweder nur gleiche Strukturen parallel oder auch unterschiedliche Strukturen durch eine variable Ansteuerung der Mikrospiegel sehr schnell, präzise und vor allem gleichzeitig herstellen.

Bei der erfindungsgemäßen Vorrichtung kann die Aufteilung des Laserstrahls bzw. die räumliche Strahlformung auf unterschiedliche Weise erfolgen. Sie kann durch Einsatz passiver Elemente, wie beispielsweise DOE's (Diffraktive Optische Elemente) in Form von Phasen oder Amplitudenmasken, oder auch mittels Mikrolinsenarrays oder durch aktive, vorzugsweise dynamisch anpassbare DOE's, Raumlichtmodulatoren (SLM) oder digitale Lichtprozessierung (DLO, Digital Light Processing) über mikroelektromechanischen (MEMS) oder mikrooptischelektromechanische (MOEMS) Elemente sowie Kombinationen dieser Elemente bewirkt werden. Es können somit beliebige Intensitätsverteilungen, wie zum Beispiel mehrere Brennpunkte oder beliebig geformte Brennpunkte oder fokale Brennvolumina erzeugt werden, die das Schreiben von je einer Struktur mit mehreren ggf. geformten Brennpunkten bzw. Brennvolumina erlauben. Besonders vorteilhaft sind DOE's zur Phasenmodulation, da diese im Vergleich zu DOE's mit Amplitudenmasken keine oder nur geringe Leistungsverluste aufweisen. Eine Verwendung von aktiven (transmittiven oder reflektiven) räumlichen Lichtmodulatoren ist außerdem möglich. Als Maske kann mit Vorteil ein eindimensionales Gitter mit einem Gitterabstand von vorzugsweise weniger als 10 µm, bevorzugt bis 1 µm oder sehr besonders auch bis hinunter zu 100 nm, oder ein zweidimensionales Array mit einem Pixelabstand von weniger als 10 µm, vorzugsweise von 2 µm oder weniger, verwendet werden. Die Aufteilung des Laserstrahls in dynamisch anpassbare Brennpunkte bzw. Brennvolumina gestattet es insbesondere, dass sich die Materialeigenschaften der herzustellenden Struktur kontrolliert anpassen lassen. Beispielsweise lassen sich so für optische oder photonische Anwendungen Brechzahlprofile einstellen, variable mechanische Eigenschaften, was besonders vorteilhaft bei der Herstellung von Gerüststrukturen im Tissue Engineering oder auch in speziellen Drug Delivery-Strukturen ist, variable dielektrische, piezoelektrische oder auch magnetische Eigenschaften, deren Eigenschaftsprofile in vorteilhafter Weise neuartige Designs und Konstruktionen zulassen, da diese individuell auf die jeweilige Fragestellung angepasst werden können.

Es können außerdem mehrere Fokussieroptiken Verwendung finden. Diese können dann relativ zum Trägermaterial (Substrat) bewegt werden, so dass gleichzeitig mehrere Strukturen (mit identischer oder mit unterschiedlicher Gestalt) mit jeweils einem Brennpunkt bzw. jeweils einem fokalem Brennvolumen geschrieben werden können. Die Verwendung mehrerer Fokussieroptiken erfordert die Aufteilung der Laserleistung durch konventionelle Strahlteiler in mehrere Strahlen, die jeweils zu einer Fokussieroptik geführt werden. Schließlich ist eine Kombination der vorstehenden Strahlformungen möglich, indem zunächst ein Modulator die gewünschte Intensitätsverteilung der Strahlung erzeugt und diese anschließend durch mehrere Optiken fokussiert wird. Gleichfalls können auch jeweils ein Modulator bzw. eine Maske pro Fokussieroptik verwendet werden. Diese Variante ermöglicht, dass gleichzeitig mehrere Strukturen mit jeweils mehreren Brennpunkten oder fokalen Brennvolumina geschrieben werden können. In einer Alternative werden mehrere Fokussieroptiken zur Bearbeitung eines einzigen Körpers oder zur Erzeugung einer einzigen Struktur aus einem flüssigen oder festen Material heraus eingesetzt. Eine derartige Variante mit zwei seitlich angeordneten Fokussieroptiken ist in Fig. 10 gezeigt. Eine solche Variante kann z.B. die Bearbeitungszeit verringern. In diesen Fällen werden die einzelnen Fokussieroptiken mit einer gewählten Symmetrie, beispielsweise Spiegelsymmetrie, betrieben, wofür der Laserstrahl mit geeigneten Optiken aufgeteilt werden kann, oder aber sie werden unabhängig voneinander angesteuert.

Ebenso kann die Position des Brennpunkts (oder des fokalen (Brenn-)Volumens) relativ zum zu verfestigenden Material frei gewählt werden. Es können damit verschiedene Startpunkte zur Materialmodifikation adressiert werden. Bei Verwenden eines aktiven, dynamischen Raumlichtmodulators kann jedoch grundsätzlich auch die relative Position der Brennpunkte zueinander dynamisch variiert werden. Soll ein bestimmter Punkt im Material in einem Fokusbereich bearbeitet werden, so kann dessen Lage bei bekannter Substratoberfläche (Trägeroberfläche) z.B. über eine Software korrigiert werden, während bei unbekannter Oberflächentextur die Daten eines optischen Detektionssystems beispielsweise in Form eines 3D-Scanners verwendet werden können. Dazu Folgendes:
Wichtig bei der (Mehr-Photonen-) Strukturierung (TPA/MPA) von flüssigen und/oder pastösen Materialien wie auch von festen Materialien ist die Modifikation dieser Materialien nicht nur im Volumen des Materials, sondern insbesondere auch *direkt* an der Oberfläche des Substrats. Hierfür wird in der Regel ein "Ankerpunkt" auf der Oberfläche benötigt, so dass die jeweils folgende Struktur mit einem bereits verfestigten Bereich oder eben dem Substrat Kontakt hat. Wenn das nicht der Fall ist, können bei nicht nur flächigen Strukturierungen bereits verfestigte Bereiche im flüssigen Harz von ihrer Sollposition wegdriften, was die Strukturqualität beeinträchtigt. Dies kann zu einer defekten Struktur führen. Wenn der Ankerpunkt auf dem Substrat nicht korrekt gefunden wurde, kann es beispielsweise im Falle einer additiven Strukturerzeugung passieren, dass zwar die Struktur korrekt generiert wurde, aber man sie letztendlich nicht auf der zu bearbeitenden Oberfläche wiederfindet, weil sie beim Herausentwickeln der Struktur nicht mehr am Substrat haftet und in die Entwicklerlösung verbracht wurde. Die Auffindung der "Ankerpunkte" spielt nicht nur im Falle der additiven Strukturgenerierung eine Rolle, sondern es ist für alle anderen erfindungsgemäß möglichen Applikationen häufig wichtig, dass der "Ankerpunkt" als ein Aufpunkt für die Strukturierungsaufgabe zuverlässig für beliebig geformte Flächen detektiert werden kann. Bevorzugte Ausführungsformen der Erfindung betreffen daher die Auffindung eines solchen Ankerpunkts (oder ggf. auch mehrerer solcher Ankerpunkte).

In der Vorrichtung der vorliegenden Erfindung kommen zur Führung des Lichtstrahls vom Laser in die Fokussiereinrichtung entweder herkömmliche dielektrische Spiegel oder Metallspiegel zur Anwendung.

Die Verwendung von Metallspiegeln (z.B. Glas beschichtet mit Gold, Silber, Aluminium oder Chrom) ermöglicht es, auch mit sehr kurzen Pulsen (im Bereich von unter 100 Femtosekunden) sehr breitbandig, d.h. über einen sehr großen Spektralbereich (Wellenlängenbereich) von ca. 450 nm bis 12 µm ungeachtet des Einfallswinkels zu strukturieren. Mit dielektrischen Spiegeln ist das nicht möglich, da das elektrische Feld der Pulse die elektronischen Bindungen der dielektrischen Schichten angreift. Zur Erzeugung von sehr kurzen Pulsen werden anstelle der sonst üblichen Ultrakurzpulslasern, wie sie für die Strukturierung von photochemisch reaktiven Materialien (Polymeren, Hybridpolymeren, Gläsern) oder moderat für Metalloberflächen eingesetzt werden können, insbesondere auch Hochleistungskurzpuls-Laser eingesetzt (Leistungsbereiche: > 4 W bis einige 10 W; Pulsenergien: von einigen nJ, z.B. 2 nJ bis zu 120 J, Pulsdauern < 120 fs). Dies ist eine wichtige Erweiterung der Arbeitsbedingungen bezüglich der Lichtquellen, da sich so erheblich größere Prozessfenster realisieren lassen, wodurch eine Vielzahl von Materialien einer Strukturierung zugeführt werden können. Darüber hinaus ist die Wechselwirkungsdauer pro eingestrahltem Puls erheblich geringer, was insbesondere bei empfindlichen Materialien von großer Relevanz sein kann. Die Strukturierung von Metallen, wie metallisierten Oberflächen oder auch geformten Körpern oder auch metallischen Schichtsystemen, insbesondere auch magnetischen Materialien, lässt sich so präzise, effizient und zuverlässig durchführen. Eine weitere Erweiterung betrifft die für den Prozess verwendbaren Laserwellenlängen. Neben den klassischen bisher verwendeten Laserwellenlängen sind erfindungsgemäß auch solche gepulste Laser einsetzbar, deren Wellenlängen unterhalb der bisher verwendeten liegen, also beispielsweise weniger als 520 nm. Dies ist besonders von Vorteil, da die Effizienz des Prozesses mit geringerer Wellenlänge steigt und das Prozessfenster somit auch deutlich vergrößert werden kann. Dies wiederum hat Einfluss auf die Vielzahl von Materialien, die sich dann so mittels des Verfahrens strukturieren lassen. Darüber hinaus sollte die erreichbare Strukturgröße bzw. auch die Auflösung der Strukturen mit geringerer Wellenlänge signifikant kleiner werden.

Als Strahlquelle können - neben den Hochleistungskurzpulslasern - grundsätzlich eine Vielzahl von gepulsten Laserlichtquellen eingesetzt werden, darunter Festkörperlaser, Dioden-gepumpte Festkörperlaser, Halbleiterlaser, Faserlaser, etc. beliebiger Wellenlänge verwendet werden. Mit besonderem Vorteil wird in einer Ausführungsform der Erfindung ein Ytterbium Lasersystem verwendet. Dessen Wellenlänge befindet sich bei Frequenzverdopplung im Bereich von grünem Licht. Vorteil von Ytterbium Lasern gegenüber Ti-Saphir-Lasersystemen, die eine Wellenlänge von ca. 800nm besitzen, ist die Wellenlänge von 1030 nm. Diese liegt bei Frequenzverdoppelung im grünen Bereich bei 515 nm, was zu einer verbesserten Auflösung führen kann. Außerdem können die zu strukturierenden Materialien effizienter bearbeitet werden als mit Lasern in Wellenlängenbereichen von ca. 800 nm. Das Prozessfenster ist hinsichtlich Materialformulierungen deutlich größer. Ein Ti-Saphir-Laser liegt bei weiterer Frequenzverdopplung mit Nachteil im UV-Bereich bei ca. 400nm. Dieser Spektralbereich ist allerdings so energiereich, dass bei einer Belichtung der meisten zu verfestigenden Materialsysteme bereits ein 1PP-Prozess stattfinden könnte, was durch Verwendung von Lasersystemen mit größerer Wellenlänge vermieden werden kann. Ti-Saphir Laser können aber andererseits wegen der kurzen Dauer ihrer Laserpulse günstig sein.

Schließlich ist eine Verwendung von Ytterbium Lasersystemen grundsätzlich möglich. Vorteilhaft ist, dass man diese Laser mit Dioden pumpen kann und keinen zusätzlichen Pumplaser und diverse andere Instrumente notwendig sind. Vorteil von Ytterbium Lasern gegenüber Nd:YAG-Lasern allerdings sind relativ kurze Pulse. Während Ytterbium-Laser Pulse weit unter einer Pikosekunde erzielen können, sind die Pulslängen eines Nd:YAG-Lasers in der Regel größer als eine Pikosekunde und somit zum Auslösen einer nicht-linearen Absorption, beispielsweise für Licht-induzierte Vernetzungsprozesse, eher ungünstig, da die Gefahr von schwach vernetzten und labilen Strukturen besteht, was zu den zuvor beschriebenen Nachteilen führen kann, sofern diese Strukturen für optische bzw. photonische Anwendungen und Produkte eingesetzt werden. Für biomedizinische Produkte und Anwendungen ist es von Vorteil ein großes Prozessfenster zu haben und so die mechanischen Eigenschaften von Strukturen über einen weiten Bereich einstellen zu können, da Zellen bevorzugt solche Plätze auf Strukturen zum Adhärieren und Proliferieren bevorzugen, die natürlichem Gewebe in ihren mechanischen Eigenschaften besonders nahe kommen.

Die erforderlichen Pulsdauern zum effizienten Auslösen einer nicht-linearen Absorption sind kleiner als eine Pikosekunde. Ultrakurzgepulste Laser im Femtosekundenbereich gestatten Mehr-Photonen-Prozesse, die generell das Auslösen von lichtinduzierten Prozessen ermöglichen. Dazu gehören das sehr lokalisierte initiieren von Vernetzungsprozessen, von Ablation, von Redox-Reaktionen, von Phasenübergängen, von Umstrukturierung durch beispielsweise Umkristallisation, usw. Im Folgenden wird die Verbesserung von Licht-Materie Wechselwirkungen und zur effizienteren Anregung einer Polymerisation beschrieben. Dazu können zusätzlich Photoinitiatoren verwendet werden. Die Repetitionsrate ist vorzugsweise zwischen 1 kHz und 80 MHz, bevorzugt zwischen 10 kHZ und 80 MHz einstellbar. Die Repetitionsrate wird dabei entweder mittels eines akusto-optischen Modulators festgelegt, oder ist mittels einer Spannungsquelle extern einstellbar, oder wird im Laser selbst bewerkstelligt (z.B. durch Q-Switches, mittels eines intracavity Mach-Zehnder Interferometers (MZI), etc.). Grundsätzlich kann auch ein elektro-optischer Modulator im Laser implementiert sein. In Abstimmung mit dem gegebenen Materialsystem können Wellenlängen im UV-Bereich, im sichtbaren Bereich sowie im Infrarotbereich verwendet werden. Die Laser können insbesondere Leistungen zwischen 100 mW und 5 W, bevorzugt zwischen 150 mW und 2 W und/oder eine Pulsdauer von unter 1 Pikosekunde und/oder eine Repetitionsrate zwischen 1 bis 80 MHz aufweisen.

Nach einem weiteren Vorschlag kann das System mit einem Scanner, insbesondere einem 2D-Scanner, kombiniert mit einer Bewegung in die dritte Raumrichtung in Z, das dann einen 3D-Scanner beschreibt, ausgestattet sein.

Die synchronisierte Bewegung von X-, Y- und Z-Richtung mit einem solchen Scannersystem (beispielsweise einem Galvo-Scanner, d.h. zwei in je einer Ebene drehbare Spiegel zum Bewegen des Laserstrahls) mit kleinem Field of View (FoV) eignet sich überraschenderweise zum Herstellen von Strukturen auf beliebig großen Flächen ohne Stitching, d.h. ohne das Aneinanderfügen von Strukturierungsfeldern, die sich notwendigerweise aus dem eingeschränkten FoV ergeben. So werden beispielsweise Fehler durch das Aneinanderfügen von Strukturen auf großen Flächen in der kontinuierlichen Struktur vermieden. Je weiter entfernt das Licht vom Zentrum des Galvospiegels auf diesen fällt, desto größer sind Abweichungen bzw. Fehler in den Strukturerzeugnissen. Diesem Problem wird üblicherweise durch entsprechend große Galvospiegel begegnet, was die Anlagen üblicherweise sehr groß und schwer (mit Gewichten von über 10 kg) macht. Dies wird erfindungsgemäß vermieden. Der Scanner kann so auch zur Beschreibung beliebig großer Flächen sehr klein sein, so dass der Footprint der Anlage, d.h. die gesamte Größe (Fläche und Höhe) der Anlage, klein bleibt und der Aufbau im Wesentlichen lediglich durch die Größe der Positioniereinrichtung und dem Lasersystem mit den für den Strukturierungsprozess notwendigen Optiken maßgeblich bestimmt wird. Gleichzeitig wird die Anordnung so gewählt, dass die drei Positionierachsen in X, Y und Z bewegt werden können (oder es wird auch nur der Scanner in Kombination mit der Z-Positionierachse in einer synchronisierten Bewegung verwendet, dann eben mit dem FoV, das gerade bei der verwendeten Optik möglich ist, wodurch größere Flächen auf Wunsch gestitcht werden können, oder es wird in alle Raumrichtungen eine synchronisierte Bewegung von Scanner und X-, Y- und Z-Positioniereinheit durchgeführt). Im Verfahren hat dies den Vorteil, dass beim Strukturierungsvorgang auf Be- und Entschleunigungstrecken verzichtet werden kann, da das Scannersystem im Gegensatz zu mechanischen oder piezoelektrischen Bewegungskomponenten, wie Positioniertischen u. dgl., eine vernachlässigbare Trägheit bzw. auch kein Kriechen aufweist. Somit wird der Strukturierungsprozess per se schon schneller. Die Schnelligkeit erhöht sich auch durch den Scanner selbst, denn der Laserstrahl kann erheblich schneller als die Probe in X- und Y-Richtung bewegt werden, da die Scannerspiegel eine vernachlässigbare Trägheit haben. Bei Vorhandensein eines solchen Scannersystems ist es daher in manchen Fällen möglich (wenn das Objekt innerhalb des FoV liegt), die Bewegung der Probe auf ein Minimum einzuschränken und auf eine solche Bewegung ganz zu verzichten. Mittels der Kombination des Scannersystems mit einer X-Y-Stage oder dem ersten, 3 rotatorische und 3 translatorische Freiheitsgrade umfassenden Träger, kann man ohne Stitching im sog. Infinite FoV Modus arbeiten, bei denen der Scanner die Feinbewegungen und die Stage oder die Vorrichtung die Grobbewegungen vornimmt. Somit kombiniert man beide Vorteile der einzelnen Systeme: die Schnelligkeit und Flexibilität des Scanners mit der großflächigen Strukturierungsmöglichkeit der Positionier-Stages. Insbesondere können mit der Vorrichtung ohne Stitching hergestellten Strukturen als Masterstruktur für weitere Abformtechniken verwendet werden. Dabei ist sowohl ein einmalige Verwendung als auch eine vielfache Verwendung desselben Masters vorgesehen. Es können auch Strukturierungen im sog. "Mixed Mode" synchronisiert zur XY-Bewegung durchgeführt werden; dabei wird das gesamte Field of View des Scanners, das durch die verwendeten Optiken variabel ist, zum Schreiben der Struktur verwendet, wobei dann die Positionierstages die XY-Bewegung zum nächsten Strukturierungspunkt vornehmen.

### Bezugszeichenliste

1 Laserquelle
2 nicht fokussierter Strahl
3 Galvo-Scanner-System
4 Drehbare Umlenkspiegel Galvo-Scanner-System
5 Umlenkspiegel
6 fokussierende Optik auf Z-Translationenstage
7 Probe mit dem zu verfestigenden Material oder ein Metallkörper
8 Chuck
9 Träger (z.B. Hexapode) mit 3 Translations- und 3 Rotationsfreiheitsgraden
10 Rotationsstage (z ist Drehachse)
11 X-Y-Translationsstage
12 zu verfestigendes Material
13 arbiträres Substrat: hier exemplarisch eine Linse gezeigt
14 Assembly mit arbiträrer Anzahl an optischen und optoelektischen Bauteilen, Chips, etc.
15 für die Strukturierungswellenlänge transparentes Substrat
16 Substrat
17 optionale (ggf. transparente) Wände
18 Begrenzungswände des Behälters
19 Befestigung an den Träger
20 Substrat an Z-Translationsachse befestigt
21 Abstandshalter
22 sehr dünnes, für die Strukturierungswellenlänge transparentes Substrat
23 auf drehbarer X-Achse gelagertes Substrat
24 seitlich angebrachte fokussierende Optiken

## Patentansprüche

1. Vorrichtung zum lasergestützten Bearbeiten eines an einem Substrat anhaftenden Materials oder eines substratassoziierten oder substratfreien Körpers oder von dessen Oberfläche, insbesondere durch TPA/MPA und/oder durch Behandlung mit einem gepulsten Laser,
aufweisend
- ein Positioniersystem (9, 10, 11), das eine Probenaufnahme aufweist, wobei die Probenaufnahme so ausgebildet ist, dass sie das Substrat (7), an dem das zu bearbeitende Material haftet oder mit dem der zu bearbeitende Körper assoziiert ist, oder
- in Abwesenheit eines Substrats - den zu bearbeitenden Körper (7) halten kann,
- eine Laserquelle (1), die Laserpulse bzw. Laserpulsfolgen aussenden kann,
und
- eine Fokussieroptik (6), die die Laserpulse bzw. Laserpulsfolgen so formen kann, dass diese in einem Brennpunkt oder einem fokalen Volumen im Bereich des zu bearbeitenden Materials bzw. Körpers derart auftreffen, dass dort eine 2- oder
Mehrphotonenpolymerisation stattfinden kann, oder dass diese in einem Brennpunkt oder in einem fokalen Volumen im Bereich des Körpers derart auftreffen, dass in diesem Brennpunkt oder fokalen Volumen befindliches Material den gewünschten chemischen und/oder physikalischen Veränderungen unterworfen wird,
**dadurch gekennzeichnet, dass** die Probenaufnahme einen Chuck in Form eines Hohlkörpers (8) umfasst oder aus einem solchen Chuck besteht, dessen obere Seite als Lochplatte mit oder ohne Nuten zur Lagerung des Substrats oder Körpers ausgestaltet ist und der eine Absaugöffnung zur steuerbaren Luftabsaugung aufweist.

2. Vorrichtung nach Anspruch 1, worin die Lochplatte des Chucks abnehmbar gestaltet und der Rest des Hohlkörpers so ausgestaltet ist, dass seine Oberseite durch verschieden große und/oder verschieden geformte Lochplatten abgeschlossen werden kann, und/oder worin der Chuck in mehrere Bereiche unterteilt ist, deren Luftabsaugung getrennt voneinander gesteuert werden kann.

3. Vorrichtung nach einem der Ansprüche 1 und 2, worin der Chuck zum Ausgleich eines Keilfehlers genutzt werden kann.

4. Vorrichtung nach einem der voranstehenden Ansprüche, worin das Positioniersystem drei translatorische und drei rotatorische Freiheitsgrade ermöglicht.

5. Vorrichtung nach Anspruch 4, worin das Positioniersystem einen einzigen oder ersten Träger (9) in Form einer Einrichtung mit bis zu sechs auf einer ersten Basis montierten Beinen umfasst oder hieraus besteht, deren Länge und Winkel variabel ist/sind und die mit einer zweiten Basis in geeigneter Anordnung verbunden sind.

6. Vorrichtung nach Anspruch 5, worin das Positioniersystem einen zweiten Träger (10; 11), der eine Bewegung in X-Y-Richtung (11) und/oder Z-Achse ausführen kann und/oder eine Rotationsachse (10) aufweist.

7. Vorrichtung nach Anspruch 6, wobei der erste Träger (9) auf oder an dem zweiten Träger (10; 11) befestigt ist oder der zweite Träger (9) auf oder an dem ersten Träger (10;11) befestigt ist, insbesondere mit Hilfe von Klemmen, oder wobei der erste Träger (9) in den zweiten Träger (10;11) eingebettet und/oder mit Hilfe eines Ansaugvakuums befestigt und/oder wobei der zweite Träger (9) mit der Probenaufnahme verschraubt ist.

8. Vorrichtung nach Anspruch 6, worin bei dem zweiten Träger eine Rotationsachse (10) auf eine in X-Y-Richtung bewegbare Positioniereinheit (11) montiert ist, wobei die Rotationsachse eine in Z-Richtung ausgerichtete Stange ist, deren Länge vorzugsweise veränderbar ist, oder worin der zweiteTräger aus mehreren Teilträgern (Teil-Positionierstages) aufgebaut ist, wobei der zweite Träger jeweils vorzugsweise luftgelagert ist und/oder vorzugsweise mechanisch und/oder piezoelektrisch angetrieben werden kann.

9. Vorrichtung nach einem der Ansprüche 1 bis 3, worin das Positioniersystem einen zweiten Träger (10; 11) aufweist, der eine Bewegung in X-Y-Richtung (11) und/oder Z-Achse und/oder um eine Rotationsachse (10) ermöglicht.

10. Vorrichtung nach einem der voranstehenden Ansprüche, worin die Probenaufnahme mit einer Halterung für den Chuck versehen ist.

11. Vorrichtung nach einem der voranstehenden Ansprüche, worin sich die Fokussieroptik (6) oberhalb der Probenaufnahme befindet, derart, dass sie sich im Betrieb der Vorrichtung oberhalb des von der Probenaufnahme gehaltenen Substrats (7) oder Körpers (7) befindet.

12. Vorrichtung nach einem der voranstehenden Ansprüche, bei dem sich die Fokussieroptik (6) unterhalb der Probenaufnahme befindet, derart, dass sie sich im Betrieb der Vorrichtung unterhalb des von der Probenaufnahme gehaltenen Substrats (7) oder Körpers (7) befindet, wobei die Probenaufnahme aus einer Befestigung (19) besteht oder diese umfasst, die eine vom Positioniersystem (9, 10, 11) beabstandete Position des zu bearbeitenden Materials oder Körpers ermöglicht und freien Raum aufweist, um die Fokussieroptik aufzunehmen.

13. Vorrichtung nach einem der Ansprüche 1 bis 11, worin das Positioniersystem so ausgestaltet ist, dass die Probenaufnahme um eine in einer Ebene angeordnete Achse drehbar angeordnet ist, wobei diese Achse seitlich an eine Komponenten des Positioniersystems angekoppelt und vorzugsweise lateral in einer Richtung verschiebbar ist, die einen rechten Winkel mit der genannten Achse bildet, wobei die Ankopplung der um die in einer Ebene angeordneten Achse drehbaren Probenaufnahme über den ersten Träger (9) vorzugsweise wie in Anspruch 5 definiert erfolgt.

14. Vorrichtung nach einem der voranstehenden Ansprüche, umfassend mindestens einen drehbaren (4) und/oder nicht drehbaren Umlenkspiegel (5), vorzugsweise ausgewählt unter dielektrischen Spiegeln und Spiegeln mit einer metallischen Oberfläche, die insbesondere aus Gold, Silber, Aluminium oder Chrom gebildet ist, sowie Kombinationen aus dielektrischen Spiegeln und Spiegeln mit einer metallischen Oberfläche.

15. Vorrichtung nach einem der voranstehenden Ansprüche, umfassend ein dreidimensionales Scanner-System, bei dem ein 2D-Scanner mit drehbar gelagerten Spiegeln, der eine Bewegung in X- und Y-Richtung ausführen kann, mit einer Bewegung in die dritte Raumrichtung (Z) kombiniert ist, worin das Scannersystem vorzugsweise mit einem piezoelektrischen Antrieb, insbesondere einem piezoelektrischen Motor, ausgestattet ist.

16. Vorrichtung nach Anspruch 15, worin das dreidimensionale Scanner-System ein Galvo-Scanner-System mit mindestens zwei Umlenkspiegeln (4) ist.

17. Lasergestütztes Verfahren, in dem ein an einem Substrat anhaftendes Material oder ein substratassozüerter oder substratfreier Körper oder dessen Oberfläche bearbeitet werden soll, wobei das lasergestützte Verfahren insbesondere einen Laser nutzt, mit dem sich TPA/MPA ausführen lässt, und/oder bei dem mit einem gepulsten Laser eine Behandlung stattfindet, **dadurch gekennzeichnet, dass** es unter Verwendung einer Vorrichtung nach einem der Ansprüche 1 bis 16 durchgeführt wird.
